# EUROPEAN PATENT APPLICATION

(11) **EP 4 679 177 A1**
(43) Date of publication of application: **14.01.2026**
(21) Application number: 24779952.1
(22) Date of filing: 22.03.2024
(51) Int. Cl.: G03F 7/20, G21K 1/00, G21K 5/02, G21K 5/08, H05G 2/00, H05H 1/00, H05H 1/24

(54) **LIGHT SOURCE DEVICE AND LIGHT-EMITTING UNIT**

(30) Priority: 31.03.2023 JP 2023058969; 31.03.2023 JP 2023058970
(71) Applicant: Ushio Denki Kabushiki Kaisha, Minato-ku, Tokyo (JP)
(72) Inventor: ASHIZAWA, Noritaka, Tokyo 100-8150 (JP); YAJIMA, Daisuke, Tokyo 100-8150 (JP); TAKAHATA, Yoshihiro, Tokyo 100-8150 (JP)
(74) Representative: Maiwald GmbH
(86) International application number: PCT/JP2024/011264
(87) International publication number: WO 2024/203834

(57) **Abstract**

A light source apparatus according to an embodiment of the present technology is a light source apparatus that converts a liquid raw material into plasma and extracts radiation by using irradiation with an energy beam, the light source apparatus including a light-emitting unit. The light-emitting unit includes a rotating body and a shielding body. The rotating body is rotatable about a rotation axis in a direction intersecting with a direction of gravity and includes an adhesion region to which the liquid raw material adheres. The shielding body includes a space portion to rotatably house the rotating body, a first energy beam passage portion through which the energy beam to be applied to the adhesion region passes, a radiation passage portion through which the radiation passes, the radiation being generated by applying the energy beam that has passed through the first energy beam passage portion to the liquid raw material that has adhered to the adhesion region, and a shielding portion that shields an irradiation position of the energy beam with respect to the adhesion region when viewed from a direction of the rotation axis.

## Description

### Technical Field

The present invention relates to a light source apparatus and a light-emitting unit that generate X-rays, extreme ultraviolet light, and the like.

### Background Art

X-rays have been conventionally used for medical, industrial, and research applications. In the medical field, X-rays are used for such applications as chest radiography, dental radiography, and computer tomogram (CT). In the industrial field, X-rays are used for such applications as non-destructive testing and tomographic non-destructive testing to observe the inside of materials such as structures and welds. In the research field, X-rays are used for such applications as X-ray diffraction to analyze the crystal structure of materials and X-ray spectroscopy (X-ray fluorescence analysis) to analyze the constituent composition of materials.

Extreme ultraviolet light (hereinafter referred to as EUV light) having a wavelength of 13.5 nm, which is in the soft X-ray region having a relatively long wavelength among X-rays, has been recently used for exposure light. Here, the base material of an EUV lithography mask including fine patterns is a reflective mirror having a stacked structure in which a multilayer film (e.g., molybdenum and silicon) for reflecting EUV light is provided on a substrate made of low-thermal-expansion glass. A material that absorbs radiation having a wavelength of 13.5 nm is then patterned on the multilayer film, so that an EUV mask is formed.

In addition, the size of unacceptable defects in EUV masks is much smaller than that of conventional ArF masks, and the unacceptable defects are difficult to detect. In this regard, EUV masks are inspected using radiation having a wavelength that matches the wavelength operated in lithography, which is usually called an actinic inspection. For example, when performed using radiation having a wavelength of 13.5 nm, the actinic inspection can detect defects with resolution better than I0 nm.

EUV light source apparatuses generally include a discharge produced plasma (DPP) light source apparatus, a laser assisted discharge produced plasma (LDP) light source apparatus, and a laser produced plasma (LPP) light source apparatus.

The DPP light source apparatus applies high voltage between electrodes between which a gaseous plasma raw material (discharge gas) containing EUV radiation species is supplied to generate a high-density high-temperature plasma by the discharge, thereby utilizing the extreme ultraviolet light radiated from the plasma.

The LDP light source apparatus is obtained by improving the DPP light source apparatus. For example, a liquid high-temperature plasma raw material (e.g., Sn (tin), Li (lithium), etc.) containing EUV radiation species is supplied to the surface of the electrode (discharge electrode) at which discharge is generated. The material is then irradiated with an energy beam (e.g., electron beam, laser beam, etc.) to vaporize the material, and then high-temperature plasma is generated by discharge.

The LPP light source apparatus generates high-temperature plasma by exciting EUV radiation species by a laser beam or the like. As this type of light source apparatuses, a light source apparatus is known, which generates plasma by focusing a laser beam on a droplet of Sn (tin) or Li (lithium) that has been ejected in the form of a minute liquid droplet, which is a target material for EUV radiation, and by exciting the target material.

### Citation List

### Patent Literature

Patent Literature 1: Japanese Patent Application Laid-open No. 2014-216286

### Disclosure of Invention

### Technical Problem

The light source apparatus described in Patent Literature 1 includes a disk-shaped rotating body, a motor that causes the rotating body to rotate, a cover-like structure that surrounds the rotating body via a gap, and a first reservoir that is provided inside the cover-like structure and stores a liquid high-temperature plasma raw material. Part of the rotating body is immersed in the high-temperature plasma raw material.

When the rotating body rotates, part of a surface of the rotating body is coated with the liquid high-temperature plasma raw material. An opening is provided to part of the cover-like structure. A surface of the rotating body, to which the high-temperature plasma raw material is applied, is exposed from the opening. An energy beam is applied to the high-temperature plasma raw material from an energy beam supply apparatus via the aperture, and EUV radiation is generated.

This method corresponds to a so-called LPP method, in which the liquid plasma raw material is supplied to an energy beam irradiation region by centrifugal force of the rotating body, and there is no need to supply the liquid plasma raw material as a droplet. Therefore, it is possible to obtain high-brightness radiation with a relatively simple configuration as compared to the method of focusing a laser beam on a droplet.

Although debris is generated along with the irradiation with the energy beam with respect to the plasma raw material, the rotating body is surrounded by the cover-like structure, and thus debris is prevented from scattering.

In such a manner, there is a need for a technology of preventing debris generated by irradiation with an energy beam from scattering to the outside of a shielding body.

In view of the circumstances as described above, it is an object of the present technology to provide a light source apparatus and a light-emitting unit that are capable of preventing debris from scattering to the outside of a shielding body.

### Solution to Problem

In order to achieve the object, a light source apparatus according to an embodiment of the present technology is a light source apparatus that converts a liquid raw material into plasma and extracts radiation by using irradiation with an energy beam, the light source apparatus including a light-emitting unit.

The light-emitting unit includes a rotating body and a shielding body.

The rotating body is rotatable about a rotation axis in a direction intersecting with a direction of gravity and includes an adhesion region to which the liquid raw material adheres.

The shielding body includes a space portion to rotatably house the rotating body, a first energy beam passage portion through which the energy beam to be applied to the adhesion region passes, a radiation passage portion through which the radiation passes, the radiation being generated by applying the energy beam that has passed through the first energy beam passage portion to the liquid raw material that has adhered to the adhesion region, and a shielding portion that shields an irradiation position of the energy beam with respect to the adhesion region when viewed from a direction of the rotation axis.

In this light source apparatus, the energy beam is applied to the region in which the liquid raw material adheres to the rotating body. In addition, as viewed from the direction of the rotation axis of the rotating body, the irradiation position of the energy beam is shieled. This makes it possible to prevent debris generated by irradiation with an energy beam from scattering to the outside of the shielding body.

The shielding body may include a front surface portion to which the first energy beam passage portion, the radiation passage portion, and the shielding portion are provided, a back surface portion opposed to the front surface portion, and a side portion. In this case, the space portion may be a space surrounded by the front surface portion, the back surface portion, and the side portion.

The shielding body may include a second energy beam passage portion provided to the front surface portion, through which the energy beam reflected by the adhesion region passes.

The first energy beam passage portion, the radiation passage portion, and the second energy beam passage portion may be respectively located in different openings provided to the front surface portion.

The front surface portion may include three openings of a first opening, a second opening, and a third opening. In this case, the first energy beam passage portion may be located in the first opening, the radiation passage portion may be located in the second opening, and the second energy beam passage portion may be located in the third opening.

The light source apparatus may further include a beam source that applies the energy beam. In this case, the beam source may cause the energy beam to be incident on each of the first energy beam passage portion and the adhesion region diagonally with respect to the rotation axis.

The liquid raw material may be tin, lithium, gadolinium, terbium, gallium, bismuth, indium, or an alloy containing at least one of those materials.

The light source apparatus may further include: a chamber that is capable of maintaining a vacuum atmosphere, the shielding body being disposed inside the chamber; and a first exhaust section that is connected to communicate with the space portion of the shielding body and is capable of exhausting the space portion.

The shielding body may include a connection section to which the first exhaust section is connected. In this case, the connection section may include at least one of a connection port provided to the side portion, a connection port provided to the front surface portion, or a connection port provided to the back surface portion.

The light source apparatus may further include a gas supply section that generates a gas flow toward the space portion from an outside of the shielding body.

The gas supply section may include a gas supply port located near at least one of the first energy beam passage portion or the radiation passage portion.

The first exhaust section may include an exhaust device disposed outside the chamber, and a debris trap that is disposed between the chamber and the exhaust device and captures debris generated by applying the energy beam to the adhesion region.

The light source apparatus may further include a second exhaust section that is connected to communicate with an inner space of the chamber and is capable of exhausting the inner space such that a pressure of the space portion of the shielding body is lower than a pressure of an outside of the shielding body.

A light-emitting unit according to an embodiment of the present technology is a light-emitting unit that converts a liquid raw material into plasma and extracts radiation by using irradiation with an energy beam, the light-emitting unit including the rotating body and the shielding body.

### Advantageous Effects of Invention

According to the present invention, it is possible to prevent debris generated by irradiation with an energy beam from scattering to the outside of a shielding body. Note that the effects described herein are not necessarily limitative, and any effect described in the present disclosure may be provided.

### Brief Description of Drawings

[Fig. 1] Fig. 1 is a schematic view showing a configuration example of a light source apparatus according to a first embodiment of the present invention.
[Fig. 2] Fig. 2 is a schematic view showing a configuration example of a plasma generation mechanism.
[Fig. 3] Fig. 3 is a cross-sectional view taken along the line A-A of Fig. 2.
[Fig. 4] Fig. 4 is a cross-sectional view taken along the line A-A of Fig. 2.
[Fig. 5] Fig. 5 is a schematic view showing a configuration example of a plasma generation mechanism.
[Fig. 6A] Fig. 6A is a cross-sectional view taken along the line B-B of Fig. 5.
[Fig. 6B] Fig. 6B is a cross-sectional view taken along the line B-B of Fig. 5.
[Fig. 7] Fig. 7 is a schematic view showing a configuration example of a plasma generation mechanism.
[Fig. 8] Fig. 8 is a schematic view showing a configuration example of a plasma generation mechanism.
[Fig. 9] Fig. 9 is a cross-sectional view taken along the line C-C of Fig. 8.
[Fig. 10] Fig. 10 is a schematic view showing a configuration example of a plasma generation mechanism.
[Fig. 11A] Fig. 11A is a cross-sectional view taken along the line D-D of Fig. 10.
[Fig. 11B] Fig. 11B is a cross-sectional view taken along the line E-E of Fig. 10.
[Fig. 12] Fig. 12 is a schematic view showing a configuration example of a plasma generation mechanism.
[Fig. 13] Fig. 13 is a schematic view showing a configuration example of a plasma generation mechanism.
[Fig. 14] Fig. 14 is a schematic view showing a configuration example of a plasma generation mechanism.
[Fig. 15] Fig. 15 is a schematic view showing a configuration example of a debris trap.
[Fig. 16] Fig. 16 is a schematic view showing an example of a connection position of a pipe member.
[Fig. 17] Fig. 17 is a schematic view showing an example of a connection position of a pipe member.
[Fig. 18] Fig. 18 is a schematic view showing an example of a connection position of a pipe member.
[Fig. 19] Fig. 19 is a schematic view showing a configuration example of a plasma generation mechanism.
[Fig. 20] Fig. 20 is a schematic view showing a configuration example of a plasma generation mechanism.
[Fig. 21] Fig. 21 is a schematic view showing a configuration example of a plasma generation mechanism.

### Mode(s) for Carrying Out the Invention

Hereinafter, embodiments according to the present technology will be described with reference to the drawings.

### <First Embodiment>

### [Basic Configuration of Light Source Apparatus]

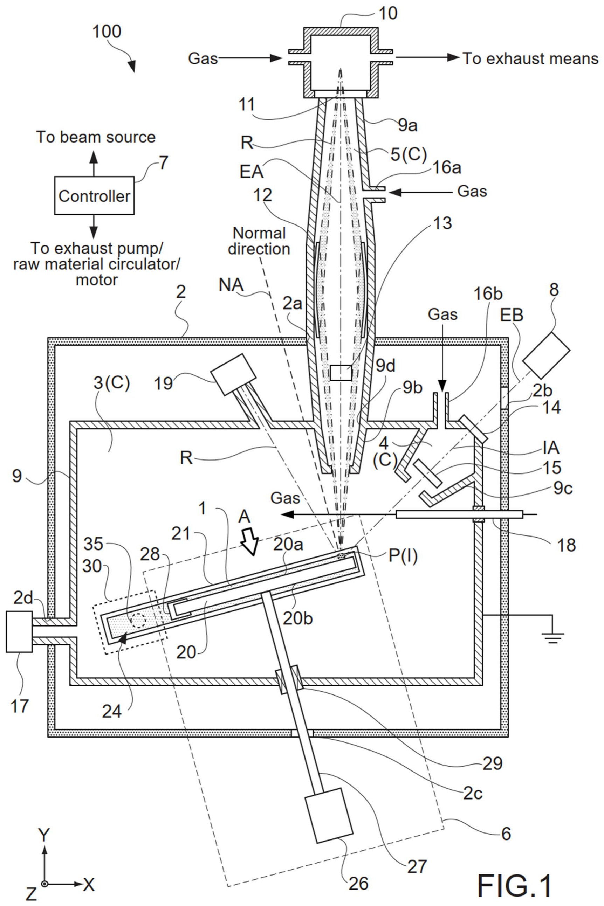

Fig. 1 is a schematic view showing a configuration example of a light source apparatus according to a first embodiment of the present invention.

A light source apparatus 100 is a laser produced plasma (LPP) light source apparatus. In other words, the light source apparatus 100 is a light source apparatus that converts a plasma raw material 1 into plasma and extracts radiation R by using irradiation with an energy beam EB.

Note that in the present disclosure the radiation R includes light (electromagnetic waves) emitted from plasma P, e.g., light in the soft X-ray region such as EUV light, and hard X-rays with higher energy.

If EUV light is emitted as the radiation R, an EUV raw material is used as a plasma raw material 1. For example, liquid Sn (tin) or Li (lithium) is used as the raw material for emitting EUV light. Sn and Li are solid at room temperature, but when irradiated with the energy beam EB, they are used in a liquid state.

If X-rays are emitted as the radiation R, an X-ray raw material is used as the plasma raw material 1. For example, the X-ray raw material is a metal in a liquid state at room temperature, such as gallium (Ga), a gallium alloy, or a Sn compound.

Fig. 1 is a schematic cross-sectional view of the light source apparatus 100 taken along the horizontal direction at a predetermined height position from an installation surface when viewed from above.

In Fig. 1, for the purpose of easy understanding of the configuration and operation of the light source apparatus 100, illustration of cross-sections is omitted for portions for which configurations or the like of cross-sections do not have to be described.

Hereinafter, description may be given assuming that the X-direction denotes the left-right direction (the positive side of the X-axis is the right side, and the negative side thereof is the left side), the Y-direction denotes the front-rear direction (the positive side of the Y-axis is the front side, and the negative side thereof is the rear side), and the Z-direction denotes the height direction (the positive side of the Z-axis is the upper side, and the negative side thereof is the lower side). Of course, when the present technology is applied, the orientations in which the light source apparatus 100 is used, and the like are not limited.

The light source apparatus 100 includes an enclosure 2, a vacuum chamber 3, an energy beam incident chamber 4, a radiation emission chamber 5, a plasma generation mechanism 6, a controller 7, and a raw material supply device 30. Note that Fig. 1 schematically shows the raw material supply device 30 by a dashed frame.

In the example shown in Fig. 1, the enclosure 2 is configured to have a substantially cubic outer shape. Note that the shape of the enclosure 2 is not limited to the cubic shape, and any cubic shape may be used.

The enclosure 2 includes an emission hole 2a formed in a front surface, an incidence hole 2b formed in a right-side surface, a through-hole 2c formed in a rear surface, and a through-hole 2d formed in a left side surface.

The material of the enclosure 2 is not limited, and a metal enclosure is used, for example.

In this embodiment, an emission axis EA of the radiation R is set so as to pass through the emission hole 2a of the front surface and extend in the Y-direction (front-rear direction). The radiation R such as X-rays or EUV light is extracted along the emission axis EA and emitted from the emission hole 2a toward the front side.

In addition, in this embodiment, an incidence axis IA of the energy beam EB is set so as to extend from the incidence hole 2b of the right-side surface in a left oblique direction toward the rear side.

As shown in Fig. 1, a beam source 8 that emits the energy beam EB is installed outside the enclosure 2. The beam source 8 is installed to allow the energy beam EB to enter the enclosure 2 along the incidence axis IA.

An electron beam or laser beam can be used as the energy beam EB. For the configuration of the beam source 8, any configuration capable of emitting those energy beams EB may be adopted.

The light source apparatus 100 is provided with a chamber section C including a plurality of chambers. Specifically, the chamber section C includes the vacuum chamber 3, the energy beam incident chamber (hereinafter, simply referred to as incident chamber) 4, and the radiation emission chamber (hereinafter, simply referred to as emission chamber) 5. The vacuum chamber 3, the incident chamber 4, and the emission chamber 5 are spatially connected to each other. In other words, the vacuum chamber 3 and the incident chamber 4 are coupled to each other. Similarly, the vacuum chamber 3 and the emission chamber 5 are coupled to each other.

The incident chamber 4 is formed to be located on the incidence axis IA of the energy beam EB, and the emission chamber 5 is formed to be located on the emission axis EA of the radiation R. In addition, a mechanism that generates plasma P is provided in the vacuum chamber 3.

In this embodiment, a chamber main body 9, an outer protrusion 9a that protrudes from a front surface of the chamber main body 9 to the front side, and two inner protrusions 9b and 9c that protrude from an inner circumferential surface of the chamber main body 9 to the inner side constitute the chamber section C (the vacuum chamber 3, the incident chamber 4, and the emission chamber 5).

A metal material is used as the material of the chamber main body 9, the outer protrusion 9a, and the two inner protrusions 9b and 9c that constitute the chamber section C.

The chamber main body 9 is formed such that its outer shape is a substantially rectangular parallelepiped shape, and the front, rear, right, and left surfaces thereof are disposed to be opposed to the front, rear, right, and left surfaces of the enclosure 2, respectively.

In addition, the chamber main body 9 is disposed such that the front-right corner between the front surface and the right-side surface is located on the incidence axis IA of the energy beam EB.

As shown in Fig. 1, an emission hole 9d is formed in the front surface of the chamber main body 9. The emission hole 9d is formed at a position aligned with the emission hole 2a formed in the front surface of the enclosure 2 on the emission axis EA of the radiation R.

The outer protrusion 9a is formed to protrude to the front side from a circumferential portion of the emission hole 9d of the chamber main body 9. The outer protrusion 9a is configured to protrude to the front side beyond the emission hole 2a of the enclosure 2 to a large extent so as to be inscribed in the emission hole 2a of the enclosure 2.

In addition, the inner protrusion 9b is formed on the inner side of the chamber main body 9 so as to protrude from the circumferential portion of the emission hole 9d to the inner side.

The space surrounded by the outer protrusion 9a and the inner protrusion 9b functions as the emission chamber 5. The outer protrusion 9a and the inner protrusion 9b themselves that are members constituting the emission chamber 5 can also be referred to as an emission chamber.

The outer protrusion 9a and the inner protrusion 9b may be formed integrally with the chamber main body 9 or may be separately formed and then connected to the chamber main body 9.

The emission chamber 5 is configured to have a cone shape with the emission axis EA of the radiation R as the central axis. The emission chamber 5 is configured such that its cross-sectional area at the center portion in the direction of the emission axis EA of the radiation R is large, and the cross-sectional area becomes smaller toward the front and rear end portions. In other words, the emission chamber 5 has a shape that is narrowed toward the front and rear end portions. In addition, the emission chamber 5 is provided with openings (apertures), through which the radiation R passes, at the front and rear end portions.

A utilization apparatus such as a mask inspection apparatus is connected to a front-side end portion of the emission chamber 5 (a front-side end portion of the outer protrusion 9a). In the example shown in Fig. 1, an application chamber 10 is connected as a chamber constituting part of the utilization apparatus. The pressure inside the application chamber 10 may be an atmospheric pressure. In addition, the inside of the application chamber 10 may be purged by introducing gas (e.g., inert gas) through a gas inlet passage, if necessary. In addition, gas inside the application chamber 10 may be exhausted by exhaust means (not shown).

A filter film 11 that physically separates a region in which the plasma P is generated from the application chamber 10 is provided between the emission chamber 5 and the application chamber 10. The filter film 11 is formed of a material capable of passing radiation therethrough and prevents the plasma raw material 1 and debris scattered along with the generation of plasma P from entering the application chamber 10.

A collector (focusing mirror) 12 that guides and focuses the radiation R, which has entered the emission chamber 5, to the inside of the utilization apparatus (inside the application chamber 10) is disposed inside the emission chamber 5. In Fig. 1, the components of the radiation R that enters the emission chamber 5 to be focused are shown by hatching.

In addition, a shielding member (central occultation) 13 is disposed inside the emission chamber 5. The shielding member 13 is disposed on the emission axis EA of the radiation R so as to be aligned with the emission hole 9d of the chamber main body 9, the emission hole 2a of the enclosure 2, and the filter film 11. In this embodiment, the shielding member 13 can block radiation components that are not focused by the collector 12.

An incident window 14 is formed at the front-right corner of the chamber main body 9. The incident window 14 is formed at a position aligned with the incidence hole 2b of the right-side surface of the enclosure 2 on the incidence axis IA of the energy beam EB.

In addition, the inner protrusion 9c is formed on the inner side of the front-right corner of the chamber main body 9 to protrude from the position surrounding the incident window 14 along the direction of the incidence axis IA of the energy beam EB.

In the inner space of the chamber main body 9, a space surrounded by the inner protrusion 9c functions as the incident chamber 4. The front-right corner portion itself of the inner protrusion 9c and chamber main body 9 constituting the incident chamber 4 can also be referred to as an incident chamber.

The inner protrusion 9c may be formed integrally with the chamber main body 9 or may be separately formed and then connected to the chamber main body 9.

The incident chamber 4 is configured to have a cone shape with the incidence axis IA of the energy beam EB as the central axis. The incident chamber 4 is configured such that its cross-sectional area becomes smaller toward the inner-side end portion of the chamber main body 9 in the direction of the incidence axis IA of the energy beam EB. In other words, the incident chamber 4 has a shape that is narrowed toward the inner-side end portion. In addition, the incident chamber 4 is provided with an opening (aperture), through which the energy beam EB passes, at the inner-side end portion.

A trap mechanism for capturing the scattered plasma raw material 1 or debris is disposed inside the incident chamber 4. In the example shown in Fig. 1, a rotary window 15 that is a plate-like rotary member to pass the energy beam EB therethrough and capture the plasma raw material 1 or debris is disposed as a trap mechanism. Rotating the rotary window 15 makes it possible to increase a substantive area of a beam transmissive region of the rotary window 15 and reduce the exchange frequency of the rotary window 15.

In addition, as shown in Fig. 1, the emission chamber 5 and the incident chamber 4 are provided with gas inlet passages 16a and 16b, respectively, and gas is supplied to the inside of the emission chamber 5 and the incident chamber 4 from a gas supply apparatus (not shown). A gas with high transmittance to the radiation R is supplied to the emission chamber 5. In addition, a gas with high transmittance to the energy beam EB is supplied to the incident chamber 4.

The gas supplied to the emission chamber 5 and the incident chamber 4 may be the same type of gas or may be different types of gas. For example, argon or helium can be used as a gas with high transmittance to both the energy beam EB and the radiation R. In addition to this, the type of gas supplied to the emission chamber 5 and the incident chamber 4 is not limited.

Supplying the gas makes it possible to set the inner pressures of the emission chamber 5 and the incident chamber 4 to a higher pressure than the inner pressure of the vacuum chamber 3 and prevent the entry of debris and the like.

In the inner space of the chamber main body 9, a space excluding the inner space of the inner protrusion 9b functioning as the emission chamber 5 and the inner space of the inner protrusion 9c functioning as the incident chamber 4 functions as the vacuum chamber 3. The portion constituting the vacuum chamber 3 can also be referred to as a vacuum chamber. The vacuum chamber 3 corresponds to an embodiment of a chamber capable of maintaining a vacuum atmosphere according to the present technology.

As shown in Fig. 1, the chamber main body 9 includes a portion protruding from the through-hole 2d of the left side surface of the enclosure 2 to the outside of the enclosure 2, and the tip of the portion is connected to an exhaust pump 17. The specific configuration of the exhaust pump 17 is not limited, and any pump such as a vacuum pump may be used.

The exhaust pump 17 exhausts the vacuum chamber 3 to depressurize the vacuum chamber 3. This suppresses the attenuation of the radiation R generated in the vacuum chamber 3.

The vacuum chamber 3 does not necessarily have to be a vacuum atmosphere as long as the inside of the vacuum chamber 3 is a reduced-pressure atmosphere with respect to the incident chamber 4 and the emission chamber 5. In addition, an inert gas may be supplied to the vacuum chamber 3.

In this embodiment, a gas nozzle 18 is installed so as to extend in the left-right direction toward the region located between the incidence axis IA and the emission axis EA. The gas nozzle 18 is installed in the right-side surface of the chamber main body 9 via a seal member or the like. The gas nozzle 18 is connected to a gas supply apparatus (not shown) and supplies gas to the chamber main body 9.

In the example shown in Fig. 1, the gas is blown from the gas nozzle 18 along the left-right direction from the right side of the region located between the incidence axis IA and the emission axis EA toward the left side. This makes it possible to move the debris emitted from the plasma P in a direction away from the incidence axis IA and the emission axis EA.

The plasma generation mechanism 6 is a mechanism for generating the plasma P in the vacuum chamber 3 and emitting the radiation R (X-rays or EUV light).

The plasma generation mechanism 6 includes a disk-shaped rotating body 20 for supplying a raw material and a raw material container 21 for storing the liquid plasma raw material 1. The rotating body 20 and the raw material container 21 are disposed inside the vacuum chamber 3.

As shown in Fig. 1, the energy beam EB is incident on the disk-shaped rotating body 20. The rotating body 20 is disposed inside the vacuum chamber 3 such that an irradiation position I of the energy beam EB is disposed at a position at which the incidence axis IA and the emission axis EA intersect with each other. Note that the shape of the rotating body is not limited to the disk shape, and for example, a rotating body having a polygonal shape may be used.

The raw material container 21 is provided such that the rotating body 20 is immersed, and supplies the liquid plasma raw material 1 to the rotating body 20. For example, the rotating body 20 is rotatably held while being immersed in the liquid plasma raw material 1 of the raw material container 21, and the plasma raw material 1 adheres to a surface of the rotating body 20. The rotating body 20 rotates in such a state, so that the plasma raw material 1 is supplied to the irradiation position I of the rotating body 20. The energy beam EB is then incident on the irradiation position I of the rotating body 20, so that the plasma P is generated.

In such a manner, the raw material container 21 is provided in the vacuum chamber 3, stores the liquid plasma raw material 1, and supplies the liquid plasma raw material 1 to the irradiation position I of the energy beam EB. In addition to this, the configuration of the plasma generation mechanism 6 will be described later in detail.

The controller 7 controls the operation of each constituent part of the light source apparatus 100.

For example, the controller 7 controls the operations of the beam source 8 and the exhaust pump 17. In addition, the controller 7 controls the operations of various motors to be described later, the raw material supply device 30, and the like.

The controller 7 includes, for example, a hardware circuit necessary for a computer, such as a CPU and memories (RAM and ROM). The CPU loads a control program stored in the memory to the RAM and then executes it, so that various types of processing are executed.

As the controller 7, for example, a programmable logic device (PLD) such as a field programmable gate array (FPGA), and other devices such as an application specific integrated circuit (ASIC) may be used.

In Fig. 1, the controller 7 is schematically illustrated as a functional block, but the position at which the controller 7 is provided, and the like may be discretionally designed.

In addition, as shown in Fig. 1, in this embodiment, a radiation diagnostic section 19 is formed in a region spatially connected to the vacuum chamber 3 on the front surface side of the chamber main body 9. The radiation diagnostic section 19 is provided at a position on which the radiation R emitted in a direction different from the emission axis EA of the radiation R is incident.

The radiation diagnostic section 19 measures the state of the radiation R emitted from the plasma P. Here, the state of the radiation R is a physical state of the radiation R, such as the intensity, wavelength, or spectrum of the radiation R. For example, the radiation diagnostic section 19 is configured by a detector that detects the presence/absence of the radiation R or a measurement instrument that measures the output of radiation.

The measurement results by the radiation diagnostic section 19 are used for the diagnosis of the radiation R and for control of the operation of the raw material supply device 30 to be described later.

The raw material supply device 30 supplies the plasma raw material 1 to the raw material container 21. The specific configuration of the raw material supply device 30, a supply timing of the plasma raw material 1 by the raw material supply device 30, and the like are not limited.

### [Plasma Generation Mechanism]

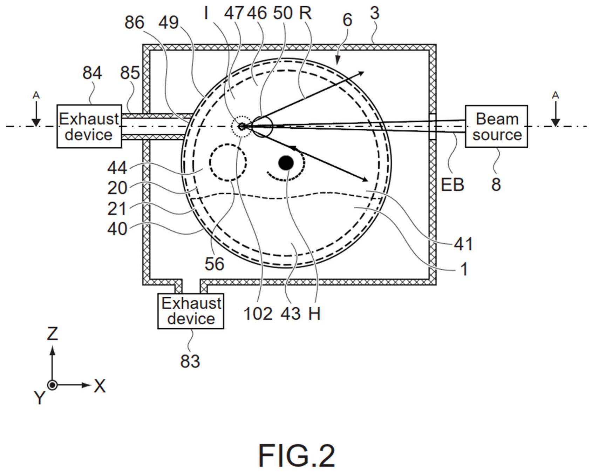

Fig. 2 is a schematic view showing a configuration example of the plasma generation mechanism 6.

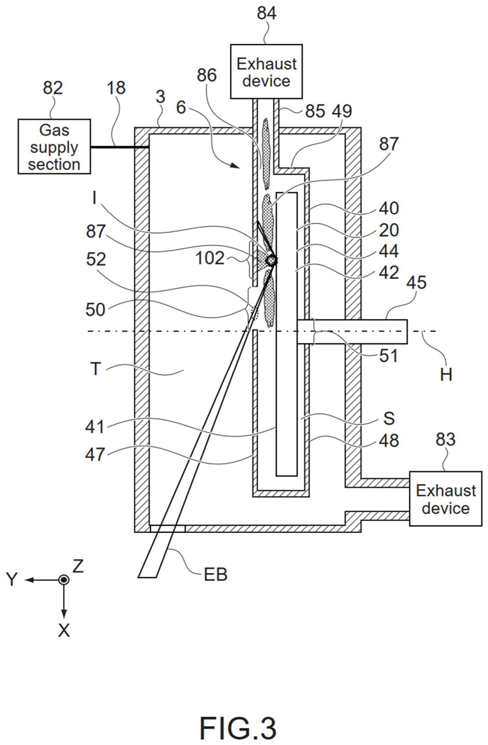

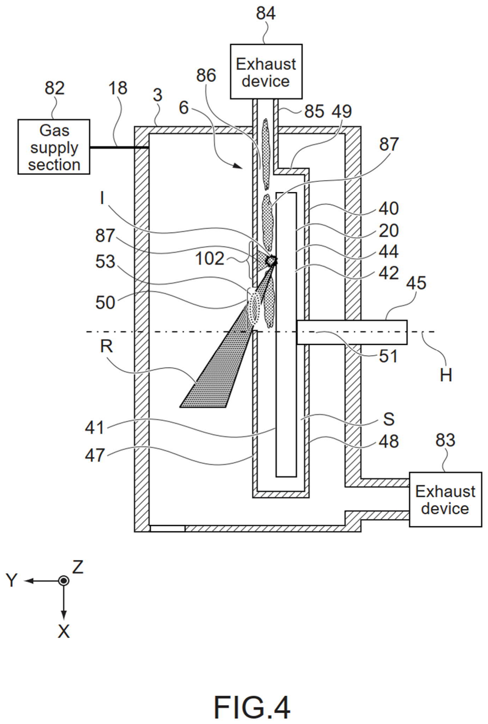

Figs. 3 and 4 are cross-sectional views taken along the line A-A of Fig. 2.

Fig. 2 shows the state of the plasma generation mechanism 6 as viewed from the upper side of Fig. 1 (the front side in the Y-direction). In addition, the beam source 8 and the energy beam EB emitted from the beam source 8 are shown. Note that in Fig. 1 the energy beam EB is emitted by the beam source 8 from the upper right side (corresponding to the left front side of Fig. 2) to the rotating body 20, but in Fig. 2 the energy beam EB is emitted from the right on the near side. In such a manner, the energy beam EB is emitted from the opposite directions in Figs. 1 and 2, but those emission directions are merely examples and the specific emission directions are not limited.

The plasma generation mechanism 6 includes the rotating body 20, the raw material container 21, and a cover structure 40. Fig. 2 shows the rotating body 20 and the raw material container 21 by the broken lines. Note that Figs. 3 and 4 omit the illustration of the raw material container 21.

The rotating body 20 includes a disk portion 44 and a shaft portion 45. The disk portion 44 has a disk shape and has a front surface 41 and a back surface 42. The front surface 41 is a surface on the near side in Fig. 2 and also a left-side surface in Figs. 3 and 4. The back surface 42 is a surface on the far side in Fig. 2 and also a right-side surface in Figs. 3 and 4. A lower part of the rotating body 20 is immersed in the plasma raw material 1 stored in the raw material container 21. Therefore, a lower part of the front surface 41 of the rotating body is a region immersed in the plasma raw material 1. Hereinafter, such a region will be described as an immersed region 43. For example, if the raw material container 21 stores a large amount of plasma raw material 1, most part of the front surface 41 of the rotating body 20 is immersed in the plasma raw material 1, and the area of the immersed region 43 increases. The shape of the immersed region 43 may vary depending on the size and shape of the rotating body 20 and the raw material container 21 in addition to the above. Similarly, a lower part of the back surface 42 is also the immersed region 43 immersed in the plasma raw material 1.

The shaft portion 45 has an elongated columnar shape and is disposed such that its circular surface comes into contact with the center of the back surface 42 of the rotating body 20. In this embodiment, the rotating body 20 is configured to be rotatable about a predetermined rotation axis. Specifically, the rotating body 20 rotates with a rotation axis H parallel to the Y-direction as the central axis. Fig. 2 shows the rotation axis H by a black circle, and Figs. 3 and 4 show the rotation axis H by the broken line.

The shaft portion 45 is disposed so as to extend along the rotation axis H. In other words, the shaft portion 45 is disposed parallel to the Y-direction. Therefore, the disk portion 44 and the shaft portion 45 integrally rotate with the rotation axis H as the central axis. As shown in Fig. 2, in this example, the rotation direction is counterclockwise as viewed from the positive direction in the Y-direction, but the rotation direction may be clockwise.

In addition, in this embodiment, the direction of the rotation axis H is the direction that intersects with the direction of gravity. Specifically, the direction of the rotation axis H is the Y-direction, which intersects with the direction of gravity (Z-direction). The direction of the rotation axis H is not limited to the above, and for example, the direction inclined obliquely to the direction of gravity is also included in the direction that intersects with the direction of gravity. Therefore, the scope of the present technology includes not only the case where the rotating body 20 rotates while being disposed parallel to the XZ plane as in this example, but also the case where the rotating body 20 rotates while being disposed obliquely to the XZ plane. In addition, the direction of the rotation axis H may be any direction that intersects with the direction of gravity.

In the front surface 41 of the rotating body 20, au upper portion of the immersed region 43 is a region to which the plasma raw material 1 adheres. Specifically, the plasma raw material 1 is lifted by the rotation of the rotating body 20 and is carried in a region, in the front surface 41, which is not immersed in the plasma raw material 1. Hereinafter, such a region is described as an adhesion region 46. The adhesion region 46 is an upper region of the immersed region 43 in the front surface 41. The adhesion region 46 can be also referred to as a carrier that carries the plasma raw material 1. Similarly, the upper side of the back surface 42 is also the adhesion region 46 to which the plasma raw material 1 adheres.

The cover structure 40 has a disk shape and has disk portions 47 and 48 and a side portion 49. The disk portions 47 and 48 are circular flat plates and are disposed parallel to the XZ plane such that their centers are located on the rotation axis H. The disk portion 47 is disposed on the near side in Fig. 2 and the disk portion 48 is disposed on the far side so as to be opposed to each other. The side portion 49 has a ring shape as viewed from the near side in Fig. 2 and is formed between the disk portions 47 and 48.

In addition, the cover structure 40 has a space S surrounded by the disk portions 47 and 48 and the side portion 49. In other words, the space S is also a disk-shaped space. In this embodiment, the rotating body 20 is rotatably housed in the space S. Specifically, as shown in Figs. 3 and 4, the rotating body 20 is housed such that, when the cross-section of the plasma generation mechanism 6 is viewed, the rectangular-shaped disk portion 44 is surrounded by the rectangular-shaped cover structure 40, which is one size larger than the rectangular-shaped disk portion 44.

This makes it possible for the rotating body 20 to rotate smoothly in the space S. For example, depending on the shape of the cover structure 40, the rotating body 20 may hit the disk portions 47 and 48 or the side portion 49 of the cover structure 40 during the rotation, which may inhibit the rotation. In this example, the shapes of the cover structure 40 and the space S are designed as appropriate, so that such inhibition to the rotation does not occur. The specific shapes of the cover structure 40 and the space S are not limited, and any shape that can rotatably house the rotating body 20 may be adopted.

Note that the raw material container 21 is also housed in the space S. For example, the raw material container 21 is disposed at the lower part of the space S, and the lower part of the rotating body 20 is immersed in the plasma raw material 1 stored in the raw material container 21. The raw material container 21 may be housed at any position that does not inhibit the rotation of the rotating body 20.

The space S corresponds to an embodiment of a space portion according to the present technology.

The front-side disk portion 47 is provided with a circular opening 50. The opening 50 is provided in an upper part, slightly leftward from the center, of the disk portion 47 when viewed from the near side in Fig. 2. The specific configurations such as position, shape, and size of the opening 50 are not limited. For example, the opening 50 may have a polygonal shape or the like.

The back-side disk portion 48 is provided with a circular through-hole 51. The through-hole 51 is provided at the center of the disk portion 48. As shown in Figs. 3 and 4, the shaft portion 45 of the rotating body 20 passes through the through-hole 51, and its right-side end portion is exposed from the cover structure 40. The right-side end portion is connected to a motor or the like, which is controlled to be driven by the controller 7, so that the rotation of the rotating body 20 is achieved.

The position or shape of the through-hole 51 is not limited, and any configuration that allows the rotating body 20 to rotate may be adopted. In addition, for example, a mechanism such as a mechanical seal may be provided as appropriate between the shaft portion 45 and the through-hole 51. This makes it possible to smoothly rotate the rotating body 20 while maintaining the air pressure of the space S.

The rotating body 20, the raw material container 21, and the cover structure 40 are formed of, for example, a material having rigidity, such as metal. Alternatively, in order to prevent degradation due to reactions with the plasma raw material 1, the energy beam EB, and the radiation R, materials having low reactivity with those materials may be used as appropriate. Other specific configurations are not limited.

The cover structure 40 corresponds to an embodiment of a shielding body according to the present technology.

The front-side disk portion 47 corresponds to an embodiment of a front surface portion according to the present technology.

The back-side disk portion 48 corresponds to an embodiment of a back surface portion according to the present technology.

The plasma generation mechanism 6 corresponds to an embodiment of a light-emitting unit according to the present technology, which converts a liquid raw material into plasma and extracts radiation by using irradiation with an energy beam.

### [Energy Beam and Radiation]

As shown in Fig. 2, in this embodiment, the beam source 8 emits the energy beam EB. Fig. 3 schematically shows part of the optical path of the energy beam EB until the arrival at the front surface 41 of the rotating body 20. The energy beam EB is emitted from the beam source 8 toward the opening 50. In other words, the energy beam EB is emitted from the right on the near side to the left on the back side in Fig. 2. This orientation corresponds to the orientation from the lower left to the upper right in Fig. 3.

In Fig. 2, the energy beam EB passes through the opening 50 and is applied to a slightly leftward position relative to the opening 50 on the front surface 41 of the rotating body 20. In this embodiment, the position of the opening 50 or the beam source 8 is adjusted as appropriate such that the irradiation position I is located in the adhesion region 46. In other words, for example, the energy beam EB is not applied to the immersed region 43.

The specific position of the irradiation position I is not limited, and the energy beam EB may be applied to any position in the adhesion region 46. In addition, Fig. 2 and the like schematically show the irradiation position I by dots, but the energy beam EB may be applied to a large range of the adhesion region 46, and the irradiation position I may be a wide irradiation surface.

By the irradiation with the energy beam EB, plasma P is generated at the irradiation position I, radiation R is emitted. The radiation R is emitted in all directions on the near side in Fig. 2, although the intensity varies depending on the angle of radiation. Fig. 2 schematically shows part of the emitted radiation R, which passes through the opening 50, by arrows. Similarly, Fig. 4 shows such part of the radiation R in a shaded pattern.

The radiation R passing through the opening 50 infiltrates the emission chamber 5, for example, and is then utilized by a utilization apparatus. In other words, in this example, in the radiation R emitted at the irradiation position I, only part of the radiation R, which passes through the opening 50, is extracted and utilized. Meanwhile, the radiation R that does not pass through the opening 50 is not utilized.

In this embodiment, the front-side disk portion 47 of the cover structure 40 is provided with an incident region 52 through which the energy beam EB to be applied to the adhesion region 46 passes. Specifically, a region of the opening 50 through which the energy beam EB passes is the incident region 52. Fig. 3 schematically shows the outline of the incident region 52 by a dashed ellipse. In such a manner, the incident region 52 is a region located within the opening 50. Note that the illustration of the incident region 52 is omitted in Fig. 2.

In addition, for example, when the energy beam EB is emitted toward the entire opening 50, the incident region 52 is the region over the entire opening 50. Thus, the shape of the incident region 52 depends on the emission direction, the emission diameter, and the like of the energy beam EB, and is not limited to any specific shape.

The incident region 52 corresponds to an embodiment of a first energy beam passage portion according to the present technology.

In addition, in this embodiment, the disk portion 47 is provided with a passage region 53 through which the radiation R passes. In this example, the radiation R passes through the entire opening 50, and thus the shape of the passage region 53 is substantially equal to the shape of the opening 50. Fig. 4 schematically shows the outline of the passage region 53 by a dashed ellipse. Note that the illustration of the passage region 53 is omitted in Fig. 2.

The above case where the shape of the passage region 53 is substantially equal to the shape of the opening 50 is also included in the case where the passage region 53 is located within the opening 50. In addition to this, the specific shape of the passage region 53 is not limited.

The passage region 53 corresponds to an embodiment of a radiation passage portion according to the present technology.

In this embodiment, the incident region 52 and the passage region 53 are located in the same opening 50. This makes it possible to achieve the plasma generation mechanism 6 with a simple configuration. The present technology is not limited to the above. For example, the disk portion 47 may be provided with two openings 50, and the incident region 52 may be located in one of the two openings 50 and the passage region 53 may be located in the other one of the openings 50. Alternatively, the disk portion 47 may be provided with three or more openings 50. Those embodiments will be described later in detail.

Note that Figs. 3 and 4 show a gas supply section 82 and a gas nozzle 18 that supply gas to the vacuum chamber 3. In addition, Figs. 2 to 4 show an exhaust device 83 connected to the vacuum chamber 3. Their specific configurations will be described later in detail.

### [Shield from Debris]

In the plasma generation mechanism 6, debris 87 is generated by the irradiation with the energy beam EB. Specifically, debris 87 is emitted to the neat side in Fig. 2 from the irradiation position I. It is known that debris is emitted at various angles, but the largest amount of debris is emitted especially on the front side in the Y-direction (the near side in Fig. 2, and the left side in Figs. 3 and 4). Hereinafter, such a direction will be described as front. Figs. 3 and 4 schematically show debris 87 emitted to the front in a shaded pattern. In such a manner, the largest amount of debris 87 is emitted to a portion, opposed to the irradiation position I, of the inner surface of the disk portion 47 (the surface on the space S side) and collides with that portion.

In this embodiment, the disk portion 47 is provided with a shielding portion 102 that shields the irradiation position I of the energy beam EB with respect to the adhesion region 46, as viewed from the direction of the rotation axis H. For example, when viewed from the near side in Fig. 2, a portion of the disk portion 47 in a predetermined range with the irradiation position I as the center is the shielding portion 102. Fig. 2 schematically shows such a range by a dashed circle.

Thus, the debris 87 emitted from the irradiation position I toward the front is blocked by the shielding portion 102, and the scattering of the debris 87 to the outside of the cover structure 40 is suppressed. Since the shielding portion 102 is provided on the front, which is the direction in which the largest amount of debris 87 is emitted, the scattering of the debris 87 can be effectively prevented.

The shielding portion 102 is not limited to the dashed circular portion as shown in Fig. 2. For example, assuming that a circle having a larger diameter is provided with the irradiation position I as the center, such a portion also shields the irradiation position I, and thus it can also be referred to as the shielding portion 102. Alternatively, if the entire disk portion 47 is considered, it also shields the irradiation position I, and thus the entire disk portion 47 can also be referred to as the shielding portion 102. Thus, any part of the disk portion 47, which shields the irradiation position I, can also be referred to as the shielding portion 102.

Even when the irradiation position I is shieled by the extremely narrow range of the disk portion 47, that range can be referred to as the shielding portion 102. In fact, such a shielding portion 102 can suppress the scattering of a certain amount of debris 87, and the above effect can be obtained. In addition, the specific size and shape of the shielding portion 102 are not limited. For example, a polygonal shielding portion 102 may be used to shield the irradiation position I.

On the other hand, a portion that does not shield the irradiation position I is not the shielding portion 102, even if the portion is part of the disk portion 47. For example, assuming that a circular portion 56 (shown as a dashed circle in Fig. 2) is located on the leftward side relative to the center of the disk portion 47, the portion 56 does not shield the irradiation position I, and thus it is not the shielding portion 102. In other words, if a certain portion is considered and if the portion does not include the irradiation position I as viewed from the near side in Fig. 2, that portion is not the shielding portion 102.

In addition, if the disk portion 47 is not located in front of the irradiation position I, the disk portion 47 does not include the shielding portion 102. For example, considering a disk portion 47 in which the opening 50 is provided in front of the irradiation position I, any portion of the disk portion 47 does not shield the irradiation position I. Therefore, such a disk portion 47 is a disk portion 47 that does not include the shielding portion 102.

In other words, as in this example, if the disk portion 47 is located in front of the irradiation position I, the disk portion 47 includes the shielding portion 102. On the other hand, if the disk portion 47 is not located in front of the irradiation position I, the disk portion 47 does not include the shielding portion 102.

In addition, in this embodiment, the energy beam EB is incident on each of the incident region 52 and the adhesion region 46 diagonally with respect to the rotation axis H. Specifically, the incident direction of the energy beam EB is a direction from the lower left to the upper right in Fig. 3A, and is a direction intersecting with the rotation axis H. For example, if the energy beam EB is incident parallel to the rotation axis H from the left side, the shielding portion 102 cannot be provided in front of the irradiation position I because the energy beam EB is blocked by the shielding portion 102 provided in front of the irradiation position I. Adopting a configuration in which the energy beam EB is incident obliquely as in this example makes it possible to provide the shielding portion 102 in front.

### [Exhaust Device]

In this embodiment, the plasma generation mechanism 6 further includes an exhaust device 84 and a pipe member 85 as shown in Figs. 2 to 4. In addition, the cover structure 40 is provided with a connection port 86. Note that the illustration of the exhaust device 84, the pipe member 85, and the connection port 86 is omitted in Fig. 1.

The connection port 86 is an opening to which the pipe member 85 is connected. As shown in Fig. 2, the connection port 86 is provided to the left side of the side portion 49 of the cover structure 40. The connection port 86 is not limited to the above, and for example, may be provided to the right side or upper side of the portion 49. In addition to the above, the specific configuration such as the shape or size of the connection port 86 is not limited.

The connection port 86 corresponds to an embodiment of a connection section according to the present technology.

The pipe member 85 is a member having a cylindrical shape. The pipe member 85 extends along the left-right direction in Fig. 2 and is disposed to pass through the left-side surface of the vacuum chamber 3. The right-side end portion of the pipe member 85 is connected to the connection port 86. The specific configuration such as a diameter of the pipe member 85 is not limited.

The exhaust device 84 is, for example, a pump such as a vacuum pump, and is disposed outside (left side) of the vacuum chamber 3. In addition, the exhaust device 84 is connected to the left-side end portion of the pipe member 85. In other words, the exhaust device 84 and the pipe member 85 are connected to each other so as to communicate with the space S of the cover structure 40.

In this embodiment, the space S is exhausted by the exhaust device 84 and the pipe member 85. Specifically, when the exhaust device 84 operates, the gas in the space S is suctioned through the pipe member 85, and the space S is exhausted (depressurized).

The specific configuration of the exhaust device 84 is not limited, and any device capable of exhausting the space S, such as a pump other than a vacuum pump, may be used. In addition, the exhaust device 84 may be directly connected to the cover structure 40 without the pipe member 85.

The exhaust device 84 and the pipe member 85 correspond to an embodiment of a first exhaust section according to the present technology.

The debris 87 stays around the irradiation position I as shown in the shape of cloud with a shaded pattern in Figs. 3 and 4. In addition, although not shown in the figures, the debris 87 may go around the periphery (lateral side) of the side portion 49 of the cover structure 40 or the periphery (back side) of the back-side disk portion 48. In other words, the debris 87 can stay in various positions in the space S.

In this embodiment, the debris 87 in the space S is removed by driving the exhaust device 84. Specifically, as shown in Figs. 3 and 4, the debris 87 is suctioned to pass through the pipe member 85 and released through the exhaust device 84 to the outside of the vacuum chamber 3. Figs. 3 and 4 show the state in which the debris 87 at the periphery (front side) of the irradiation position I is suctioned to the upper side in the figures, but the debris 87 on the lateral side and the back side are also suctioned in the same way. In other words, the whole of the debris 87 filling the space S is suctioned to the upper side in the figures.

As described above, in the plasma generation mechanism 6 according to this embodiment, the energy beam EB is applied to the adhesion region 46 in which the plasma raw material 1 adheres to the rotating body 20. In addition, the irradiation position I of the energy beam EB is shielded when viewed from the direction of the rotation axis H of the rotating body 20. This makes it possible to prevent the debris 87 generated by the irradiation with the energy beam EB from scattering to the outside of the cover structure 40.

In addition, in this embodiment, the cover structure 40 has a disk shape, and the rotating body 20 is housed in the space S enclosed by the disk portions 47 and 48 and the side portion 49. This makes it possible to prevent the debris 87 from scattering without interfering with the rotation of the rotating body 20.

Additionally, in this embodiment, the energy beam EB and the radiation R pass through the circular opening 50. This makes it possible for the energy beam EB to be incident with high accuracy and possible to extract the radiation R with high accuracy.

In addition, in this embodiment, the space S of the cover structure 40 is exhausted. This makes it possible to efficiently remove the debris 87 generated by the irradiation with the energy beam EB.

The debris 87 has property of absorbing laser light. Therefore, when the debris 87 exists on the optical path of the energy beam EB as shown in Fig. 3, the energy beam EB is absorbed and attenuated by the debris 87 and arrives at the irradiation position I. In other words, the amount of radiation R generated at the irradiation position I is reduced.

In addition, the debris 87 also has property of absorbing radiation such as EUV light. Thus, the radiation R generated at the irradiation position I is absorbed by the debris 87 that stays around the irradiation position I. This further reduces the output of radiation R.

In addition, the debris 87 adheres to any location within the plasma generation mechanism 6. For example, the debris 87 accumulates at the boundary of the opening 50 (portion of the thickness of the ridge line), which is a cavity, and if the temperature of that portion is low, the debris 87 is not melted and thus may narrow the opening 50. In this case, the region on which the energy beam EB can be incident becomes narrower, which may lead to a decrease in the output of radiation R. In addition, in the worst case, the debris 87 may completely close the opening 50 and may inhibit the light source apparatus 100 to function.

The debris 87 adheres to various locations other than the opening 50, such as the inner surface of the cover structure 40 and the surface of the rotating body 20. This may cause problems in the driving of the plasma generation mechanism 6 or may deteriorate various mechanisms.

In the present technology, the debris 87 is removed by the exhaust device 84, so that the absorption of the energy beam EB by the debris 87 is suppressed. Further, the absorption of the radiation R by the debris 87 is also suppressed. This suppresses the decrease in the output of the radiation R. Further, since the debris 87 is less likely to adhere to various mechanisms, it is possible to prevent the diameter of the opening 50 from decreasing and the various mechanisms from deteriorating.

In addition, in the present technology, the connection port 86 is provided to the cover structure 40, the pipe member 85 is connected to the connection port 86, and the exhaust device 84 is connected to the pipe member 85. Providing this type of connection form makes it possible to efficiently remove the debris 87.

Additionally, in the present technology, the connection port 86 is provided to the side portion 49 of the cover structure 40. The debris 87 generated at the irradiation position I is scattered outward by centrifugal force due to the rotation of the rotating body 20, and a large amount of debris 87 may be distributed around the side portion 49. Providing the connection port 86 to the side portion 49 makes it possible to efficiently remove such debris 87.

In addition, in the present technology, the rotating body 20 is immersed in the plasma raw material 1 stored in the raw material container 21. This makes it possible to efficiently cause the plasma raw material 1 to adhere to the rotating body 20.

### <Second Embodiment>

A more detailed embodiment of the plasma generation mechanism 6 according to the present technology will be described as a second embodiment. In the following description, the description may be omitted or simplified for the parts similar to the configuration and action of the plasma generation mechanism 6 described in the above embodiment.

### [Configuration of Two Holes]

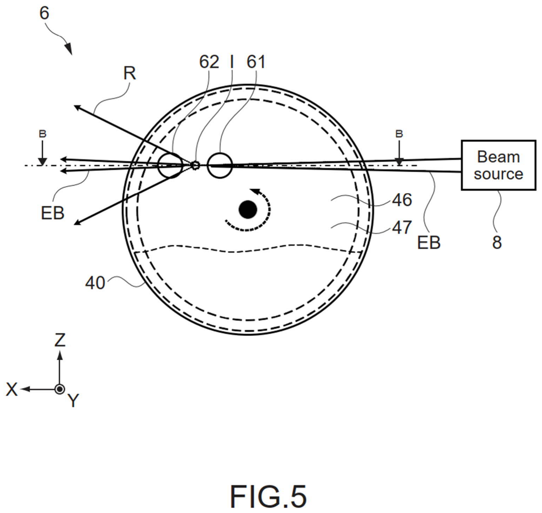

Fig. 5 is a schematic view showing a configuration example of the plasma generation mechanism 6.

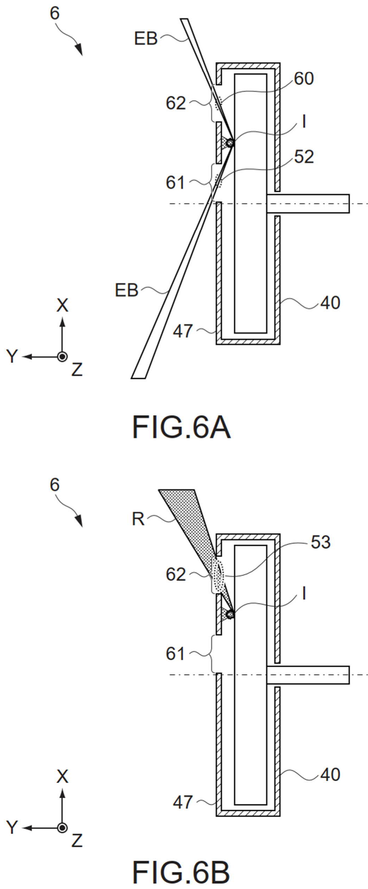

Figs. 6A and 6B are cross-sectional views taken along the line B-B of Fig. 5.

In Fig. 5 and the following figures, the illustration of the vacuum chamber 3, the exhaust device 84, and the like is omitted in some cases.

In this embodiment, the cover structure 40 includes an emission region 60, which is provided to the disk portion 47 and through which the energy beam EB reflected by the adhesion region 46 passes. In addition, two openings 61 and 62 are provided to the disk portion 47. The incident region 52 is located in the opening 61, and each of the passage region 53 and the emission region 60 is located in the opening 62.

The opening 61 has a circular shape and is provided in an upper part, slightly leftward from the center, of the disk portion 47 of Fig. 5. In other words, the opening 61 is provided at the same position as the opening 50 of Fig. 2. The opening 62 also has a circular shape and is provided at a position point-symmetric to the opening 61 with reference to the irradiation position I. The opening 61, the irradiation position I, and the opening 62 are aligned along the optical axis of the energy beam EB (Y-direction, left-right direction).

The energy beam EB emitted by the beam source 8 travels from the right on the near side to the left on the back side in Fig. 5 (from the lower left to the upper right in Fig. 6A) to be applied to the adhesion region 46. The energy beam EB is further reflected at the irradiation position I and travels from the right on the back side to the left on the near side in Fig. 5 (from the lower right to the upper left in Fig. 6A). Fig. 4 schematically shows the reflected energy beams EB by the arrows.

The emission region 60 is a region of the opening 62, through which the energy beam EB passes. Fig. 6A schematically shows the outline of the emission region 60 by a dashed ellipse. Note that the illustration of the emission region 60 is omitted in Fig. 5. In this example, the reflected light of the energy beam EB is emitted at the same angular range as that of the incident light, so that the reflected light does not pass through the entire range of the opening 62, and the emission region 60 is a partial region included in the opening 62.

On the other hand, if the energy beam EB is emitted toward the entire range of the opening 61, the angular range of the reflected light also becomes wider, and the emission region 60 may be a region over the entire opening 62. Thus, the shape of the emission region 60 depends on the emission direction, the emission diameter, and the like of the energy beam EB.

In this example, the radiation R is emitted toward the near side with the irradiation position I of Fig. 5 as the center, and only part of the radiation R that has passed through the opening 62 is utilized. Fig. 5 schematically shows the part of the radiation R by the arrows. In addition, Fig. 6B shows that part of the radiation R in a shaded pattern. In reality, the radiation R is emitted from the opening 61 side, but the illustration of that radiation R is omitted.

As shown in Fig. 5, the radiation R and the energy beam EB are emitted in a mixed state from the opening 62. Here, since the angular range of the radiation R is wider than that of the energy beam EB, it is possible to extract only the radiation R by appropriately shielding the vicinity of the center of the emitted light using a damper or the like.

In this embodiment, the radiation R passes through the opening 62, which is different from the opening 61 through which the incident light of the energy beam EB passes. This makes it possible to efficiently extract the radiation R. Note that the radiation R that has passed through the opening 61 side may be extracted and utilized.

In addition, the cover structure 40 includes the emission region 60, which makes it possible to prevent degradation of the cover structure 40 due to reflection of the energy beam EB inside the cover structure 40. Further, in this embodiment, the passage region 53 and the emission region 60 are located in the common opening 62, which makes it possible to achieve the plasma generation mechanism 6 with a simple configuration.

The emission region 60 corresponds to an embodiment of a second energy beam passage portion according to the present technology.

Note that the incident region 52 and the passage region 53 may be located in the opening 61, and the emission region 60 may be located in the opening 62. In other words, a configuration in which the radiation R is extracted from the opposite opening 61 in Fig. 5 may be adopted.

### [Arc-Shaped Opening]

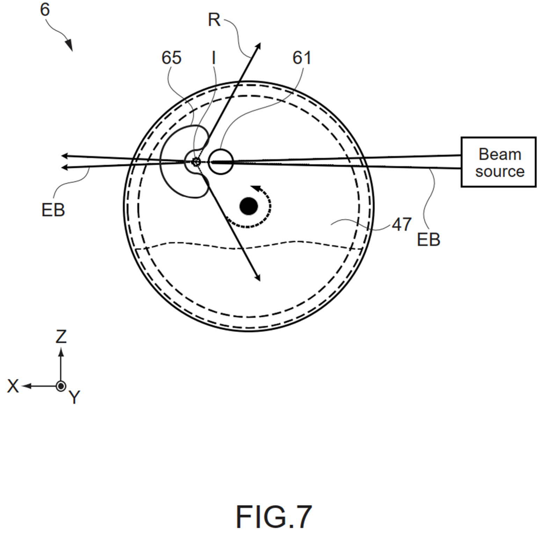

Fig. 7 is a schematic view showing a configuration example of the plasma generation mechanism 6.

In this embodiment, at least one of the incident region 52, the passage region 53, or the emission region 60 is located in an arc-shaped opening. As shown in Fig. 7, in this example, the disk portion 47 is provided with a circular opening 61 and an arc-shaped opening 65. The opening 61 is provided at the same position as the opening 61 of Fig. 5.

The opening 65 has an arc shape extending from the upper part to the lower part of the irradiation position I. Such a shape can also be referred to as a C-shape or a left-half doughnut shape. In addition, it can also be referred to as a shape obtained by connecting the openings disposed at the upper and lower parts of the irradiation position I into an arc shape.

Fig. 7 schematically shows the radiation R emitted from the opening 65 by the arrows. In this example, the radiation R is emitted in a wide angular range, which enables a larger amount of radiation R to be extracted and improves the utilization efficiency of the radiation R.

The specific shape of the opening 65 is not limited. For example, the arc-shaped opening 65 with a wider angular range may further be provided. Alternatively, the arc-shaped opening 65 may have a long hole in which two openings are connected in a straight line or connected in another curved line other than an arc shape.

In this example, the passage region 53 and the emission region 60 are located in the arc-shaped opening 65, but the incident region 52 may be located in the arc-shaped opening. In other words, the opening 61 may have an arc shape. Alternatively, in the one-hole configuration of Fig. 2, the opening 50 may have an arc shape. In this case, the incident region 52 and the passage region 53 are located in the arc-shaped opening 50.

In any example shown in Figs. 5 to 7, the incident region 52, the passage region 53, and the emission region 60 are located in the openings that are provided to the disk portion 47 and do not include the outer circumference of the disk portion 47. In other words, the openings 61 and 62 of Fig. 5 or the opening 65 of Fig. 7 are closed openings in the disk portion 47. The openings are configured as described above, which makes it possible for the energy beam EB to enter and exit and possible to extract the radiation R accurately. Note that in this example all of the openings do not include the outer circumference of the disk portion 47, but a configuration in which at least one of the openings does not include the outer circumference of the disk portion 47, and the other openings include the outer circumference (not closed within the disk portion 47) may be provided.

Note that all of the incident region 52, the passage region 53, and the emission region 60 may be located in a single opening. For example, if the opening is formed as a long hole, such a configuration can be achieved.

### [Damper]

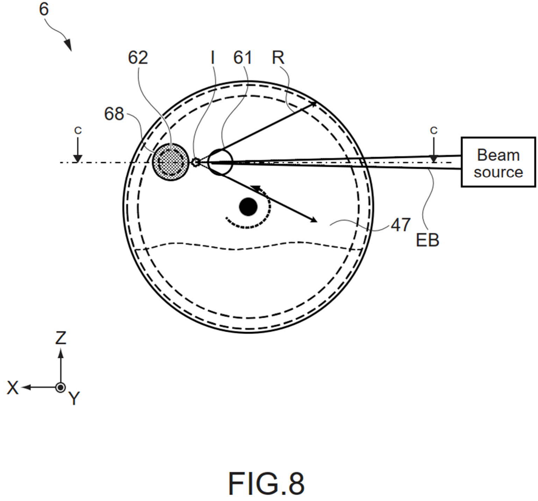

Fig. 8 is a schematic view showing a configuration example of the plasma generation mechanism 6.

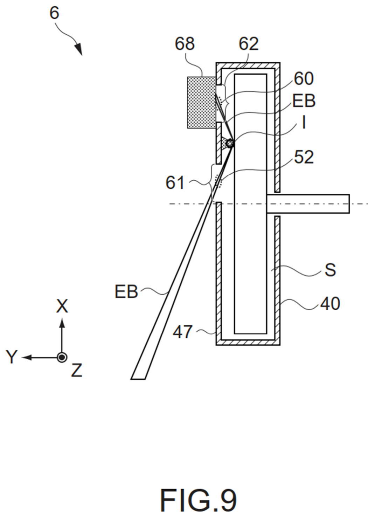

Fig. 9 is a cross-sectional view taken along the line C-C of Fig. 8.

In this embodiment, each of the incident region 52 and the passage region 53 is located in the opening 61, and the passage region 53 is located in the opening 62. In addition, the cover structure 40 also includes a damper 68 that shields the opening 62 and absorbs the energy beam EB reflected by the adhesion region 46.

In this example, the openings 61 and 62 are provided at the same positions as in Fig. 5. The damper 68 has a disk shape and has a diameter that is one size larger than the diameter of the opening 62. The damper 68 is disposed to close the opening 62 at the position of the opening 62. The specific shape of the damper 68 is not limited and may be any shape capable of closing the opening 62. For example, if the opening 62 has a polygonal shape, a polygonal shape that is one size larger than the opening 62 is adopted as the shape of the damper 68.

The damper 68 is, for example, formed of a material having highly absorbent property to the energy beam EB. For example, molybdenum and tungsten are used as materials that are resistant to molten tin. In addition, copper and gold are used as materials with good thermal conductivity. Other materials such as titanium, iron, nickel, aluminum, tantalum, and all compounds containing those materials (SUS, Ti-6Al-4V, TZM, etc.) are used. Alternatively, using those materials as the base metal, the surface may be coated with any compound such as oxide, nitride, or fluoride. Other specific configurations of the damper 68 are not limited.

As shown in Fig. 9, the reflected light of the energy beam EB is incident on the back surface of the damper 68 (the surface on the space S side) and is absorbed. For example, if the damper 68 is not disposed, the reflected light may repeatedly reflect off the inner surface of the cover structure 40, which may result in degradation of the inner surface. If the damper 68 is disposed, the reflected light is absorbed without being reflected, and the degradation of the cover structure 40 is suppressed.

Note that in this example only part of the radiation R, which passes through the opening 61, is extracted and utilized. In other words, the incident region 52 and the passage region 53 are located in the common opening 61. This makes it possible to achieve the plasma generation mechanism 6 with a simple configuration.

In the one-hole configuration as shown in Fig. 2, the damper 68 may be disposed in the position shown in Fig. 8. In other words, the damper 68 does not necessarily have to be disposed to close the opening. Similar effects can be achieved even if the damper 68 is disposed in a position where no opening exists.

### <Third Embodiment>

### [Configuration of Three Holes]

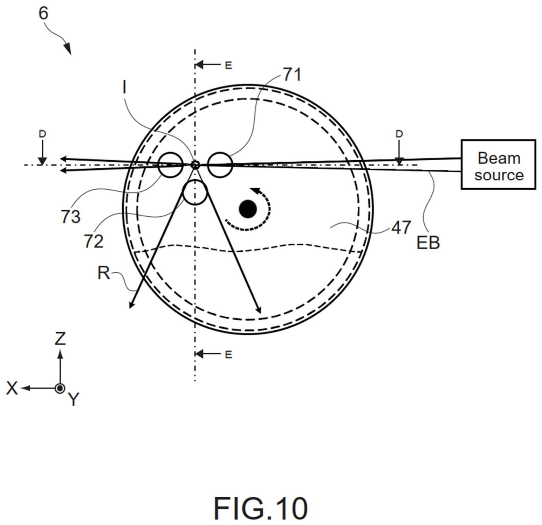

Fig. 10 is a schematic view showing a configuration example of the plasma generation mechanism 6.

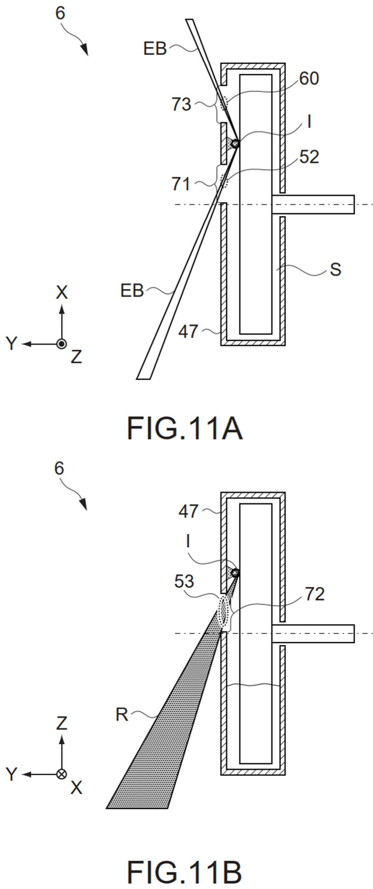

Figs. 11 are cross-sectional views of Fig. 10. Fig. 11A shows a cross-sectional view taken along the line D-D of Fig. 10. Fig. 11B shows a cross-sectional view taken along the line E-E of Fig. 10.

In this embodiment, the disk portion 47 is provided with three openings 71, 72, and 73. The incident region 52 is located in the opening 71, the passage region 53 is located in the opening 72, and the emission region 60 is located in the opening 73.

The opening 71 has a circular shape and is provided in the same position as that of the opening 61 of Fig. 5. The opening 72 also has a circular shape and is provided in the same position as that of opening 62 of Fig. 5. The opening 73 has a circular shape and is provided in the lower side of the irradiation position I. Therefore, the openings 71, 72, and 73 are provided in the directions of 3 o'clock, 6 o'clock, and 9 o'clock, respectively, with the irradiation position I as the center.

The energy beam EB travels from the right on the near side to the left on the back side in Fig. 10 (from the lower left to the upper right in Fig. 11A) and enters the space S through the opening 71 as in the example of Fig. 5. The energy beam EB is further reflected at the irradiation position I and travels from the right on the back side to the left on the near side in Fig. 10 (from the lower right to the upper left in Fig. 11A) and is emitted from the opening 73.

Meanwhile, in this example, only part of the radiation R, which passes through the opening 72 disposed on the lower side, is extracted and utilized. Fig. 11B shows the radiation R in a shaded pattern. The passage region 53 of the radiation R is a region that extends substantially in front of the opening 72.

In such a manner, in this embodiment, the incident region 52, the passage region 53, and the emission region 60 are respectively located in different openings. The energy beam EB is not emitted in a mixed state from the opening 72 from which the radiation R is extracted, which makes it possible to further efficiently extract the radiation R.

Note that the radiation R may also be extracted from the opening 71 or 73. In addition, in this example as well, it is possible to adopt a configuration in which the opening 71, 72, or 73 has an arc shape or a configuration in which the opening 71, 72, or 73 is closed by the damper 68.

The opening 71 corresponds to an embodiment of a first opening according to the present technology.

The opening 72 corresponds to an embodiment of a second opening according to the present technology.

The opening 73 corresponds to an embodiment of a third opening according to the present technology.

### <Fourth Embodiment>

### [Configuration in which Opening Is Not Closed]

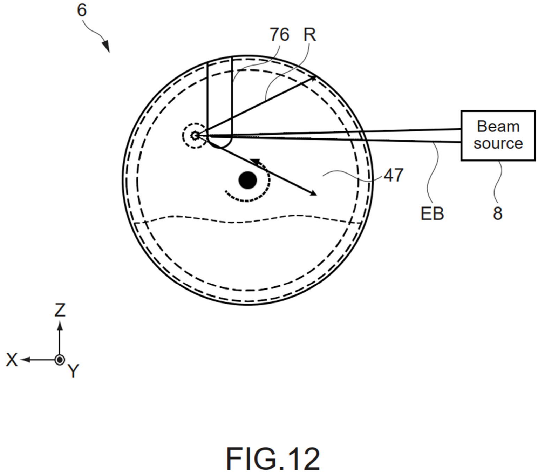

Figs. 12 to 14 are schematic views each showing a configuration example of the plasma generation mechanism 6. In any example, at least one of the incident region 52, the passage region 53, or the emission region 60 is located in an opening that is provided to the disk portion 47 and includes the outer circumference of the disk portion 47. In other words, any opening shown in Figs. 12 to 14 is an opening that is not closed in the disk portion 47.

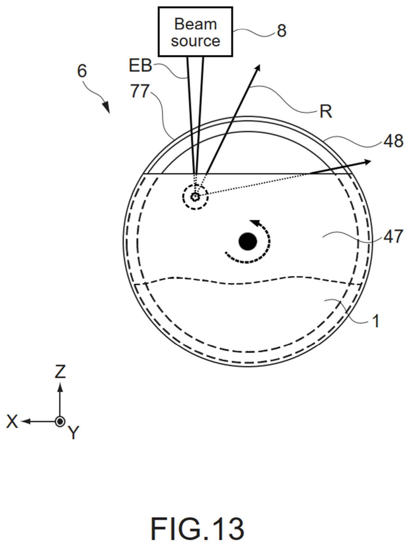

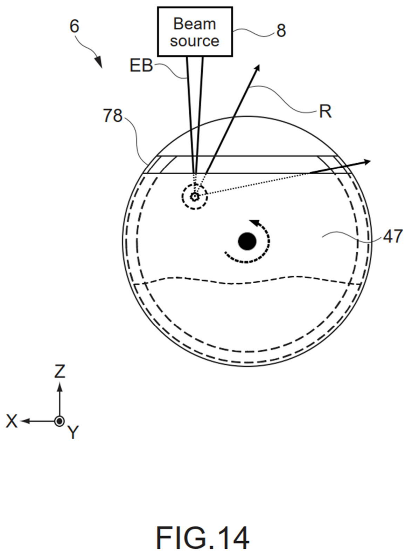

For example, in Fig. 12, an opening 76 is provided to be open upward so as to include the upper portion of the outer circumference of the disk portion 47. Similarly, an opening 77 in Fig. 13 is provided so as to include the upper-side arc of the disk portion 47. An opening 78 in Fig. 14 is provided so as to include right-side and left-side arcs of the disk portion 47.

The openings are configured as described above, which makes it possible for the energy beam EB to enter and exit and possible to extract the radiation R accurately. For example, compared to the case where the opening is closed in the disk portion 47, an opening with a larger area can be provided, which makes it possible for the energy beam EB to enter and exit and possible to extract the radiation R reliably. In addition, the radiation R can be extracted over a wide area, so that the utilization efficiency of the light source apparatus 100 is improved.

In the example shown in Fig. 12, the opening 76 has part of the shape obtained by connecting two circles in a straight line. Specifically, the shape of the lower half arc, which is obtained by arranging two circles having the same shape along the up-down direction (Z-direction) and cutting the shape connecting vertically the two circles by the upper arc of the disk portion 47, corresponds to the shape of the opening 76. In other words, the opening 76 has the shape of a long hole that extends along the up-down direction and is open upward.

This makes it possible to, for example, extract the radiation R over a wide area, thereby increasing the utilization efficiency of the light source apparatus 100. Note that the opening 76 may be configured to be disposed along the left-right direction or diagonally and to be open in the left-right direction or diagonally. In addition, in this example, the energy beam EB is incident from the right side, but it may be incident from above or other directions. Alternatively, the device may be used in such a manner that the energy beam EB is caused to be incident on one end of the long hole and the radiation R is extracted from the other end.

In the example shown in Fig. 13, the opening 77 has the shape surrounded by the arc of the disk portion 47 and one string. Specifically, the shape surrounded by the upper-side arc of the disk portion 47 and a string extending along the left-right direction (X-direction) is the shape of the opening 77.

This makes it possible to extract the radiation R over a wider range. Note that it may also be possible to adopt a configuration in which the opening 77 is disposed in a different orientation, for example, when the opening 77 has a shape surrounded by the right-side arc and a string extending along the up-down direction.

Note that in this example the back-side disk portion 48 has a circular shape without openings. This makes it possible to prevent the scattering of the plasma raw material 1 from the back side.

In the example shown in Fig. 14, the opening 78 has a shape surrounded by the arcs of the disk portion 47 and two parallel strings. Specifically, the shape surrounded by the left and right arcs of the disk portion 47 and the upper and lower strings that extend along the left-right direction and are parallel to each other is the shape of the opening 78.

In this case as well, the radiation R can be extracted from a wider range in a similar manner. Note that it may also be possible to adopt a configuration in which the opening 78 is disposed in a different orientation, for example, when the opening 78 has a shape surrounded by upper and lower arcs and two strings each extending along the up-down direction.

### <Fifth Embodiment>

### [Debris Trap]

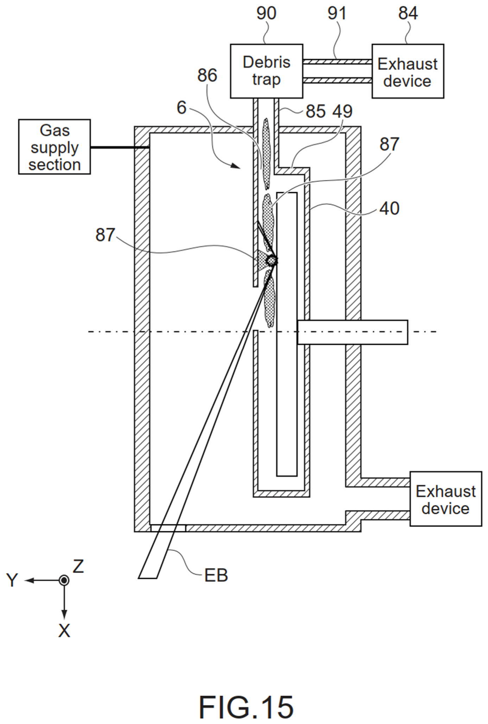

Fig. 15 is a schematic view showing a configuration example of a debris trap. In this embodiment, the plasma generation mechanism 6 further includes a debris trap 90 and a pipe member 91. In this example, similarly to Fig. 3, the connection port 86 is provided to the side portion 49 of the cover structure 40. Further, as shown in Fig. 15, the pipe member 85, the debris trap 90, the pipe member 91, and the exhaust device 84 are connected to the connection port 86 in the stated order. Note that the exhaust device 84 is connected to the right side of the debris trap 90 in Fig. 15, which schematically shows the connected state and does not limit the specific connection orientation.

The debris trap 90 captures debris 87 generated by applying the energy beam EB to the adhesion region 46. As the debris trap 90, for example, a foil trap (rotating foil trap) having a rotating function or a foil trap (static foil trap) that does not rotate and is fixed is used.

A rotating foil trap includes a plurality of foils (thin film or thin flat plate) radially disposed centering on a rotation axis disposed at the center, and captures debris 87 by rotating the plurality of foils with the rotation axis as the center.

The static foil trap mainly captures fast-moving debris 87 (especially fast-moving ions, neutral atoms, electrons, and the like of plasma raw material 1). For example, a static foil trap is used, which has a central axis and includes a plurality of foils (thin film or thin flat plate) radially disposed in a radial direction from the central axis, like a rotating foil trap. Alternatively, a static foil trap of a different type from the rotating foil trap, such as one including thin flat plates arranged in parallel, may be used.

As the debris trap 90, a foil trap combining the rotating foil trap and the static foil trap may be used. In addition to this, the specific configuration of the debris trap 90 is not limited, and any mechanism capable of capturing the debris 87 may be used.

The pipe member 91 has, for example, a shape similar to the pipe member 85. The specific configuration of the pipe member 91 is not limited. In this example, the debris trap 90 and the exhaust device 84 are connected through the pipe member 91, but the specific connection method is not limited. For example, the connection may be made without the pipe member 91. Similarly, the debris trap 90 may be directly connected to the side portion 49 of the cover structure 40 without the pipe member 85.

The debris 87 suctioned by the exhaust device 84 may be solidified in the exhaust device 84 and cause a failure of the device. In this embodiment, the suctioned debris 87 is captured by the debris trap 90, and thus the amount of debris 87 entering the exhaust device 84 is reduced. In other words, it is possible to prevent a failure of the exhaust device 84.

Alternatively, countermeasures may be taken in the exhaust device 84 itself. In other words, a mechanism corresponding to the debris trap 90 may be provided inside the exhaust device 84. In this case, similar effects can be achieved even if the debris trap 90 is not provided on the path of the debris 87.

In addition, the debris trap 90 may be a bent portion of the pipe member 85. For example, in Fig. 3, the pipe member 85 is provided as an L-shaped pipe bent to the right side in the middle, and the exhaust device 84 is connected thereto from the right side. This will slow down the debris 87 to some extent at the bent portion of the pipe member 85, and part of the debris 87 will adhere to the bent portion. Therefore, the amount of debris 87 entering the exhaust device 84 is reduced. In addition, since the speed of the debris 87 entering the exhaust device 84 is also reduced, the deterioration of the exhaust device 84 due to the collision of the debris 87 is suppressed.

This makes it possible to achieve the plasma generation mechanism 6 with a simpler configuration than in the case of providing a foil trap as the debris trap 90. Of course, there is no limitation as to how the pipe member 85 is bent. For example, the pipe member 85 may be bent into other shapes such as an S-shape. Any other shape may be appropriately selected in accordance with the configuration of the device.

### <Sixth Embodiment>

### [Connection Position of Pipe Member]

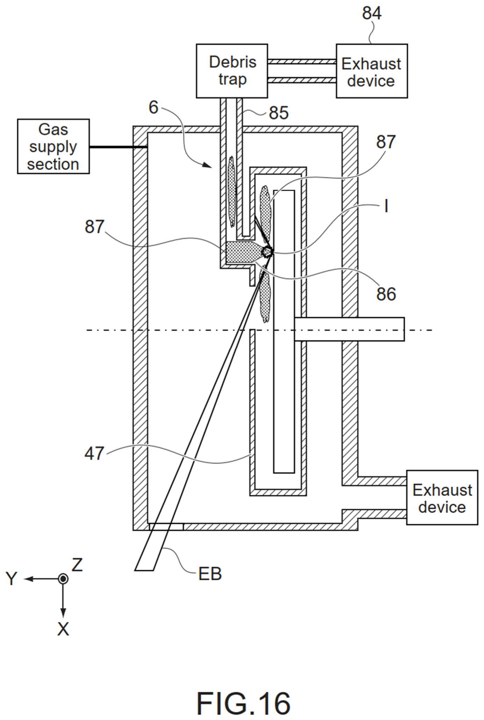

Fig. 16 is a schematic view showing an example of the connection position of the pipe member 85. In this example, the connection port 86 of the pipe member 85 is provided to the front-side disk portion 47 of the cover structure 40. Specifically, the connection port 86 is provided at a position opposed to the irradiation position I. In this example, in the pipe member 85, a portion opposed to the irradiation position I shields the irradiation position I, and thus that portion corresponds to a shielding portion.

In this example, the pipe member 85 is connected in a front direction in which the largest amount of debris 87 is emitted, which makes it possible to remove the debris 87 generated at the irradiation position I instantaneously and efficiently. In addition, especially when the pipe member 85 is bent in the middle as in this example, the debris 87 is slowed down and captured at the bent portion, and the deterioration of the exhaust device 84 is suppressed.

Alternatively, the connection port 86 may be provided at another position of the front-side disk portion 47, which is not opposed to the irradiation position I. In this case as well, the pipe member 85 may also be connected at a position relatively close to the irradiation position I, and thus the debris 87 is efficiently removed.

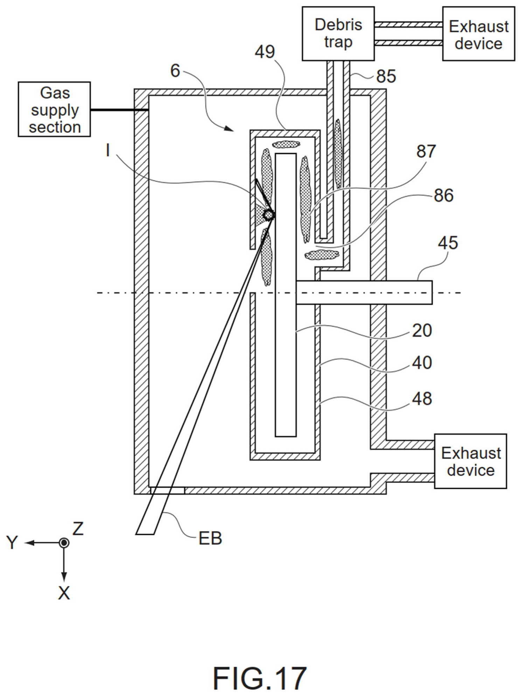

Fig. 17 is a schematic view showing an example of the connection position of the pipe member 85. In this example, the connection port 86 of the pipe member 85 is provided to the back-side disk portion 48 of the cover structure 40. The debris 87 generated at the irradiation position I may pass around the vicinity of the side portion 49 of the cover structure 40 to go around the back side. Since the pipe member 85 is connected to the back side in this example, such debris 87 can be efficiently removed.

In addition, the debris 87 that has gone around the back side may adhere to the shaft portion 45 of the rotating body 20, and the rotation of the rotating body 20 may be inhibited by the solidification of the debris 87. In this example, the debris 87 that has gone around the back side is removed, thereby preventing such inhibition of the rotation. In addition, in particular, the connection port 86 is provided near the shaft portion 45, so that the debris 87 approaching the shaft portion 45 can be efficiently removed, thereby preventing the inhibition of the rotation more reliably. In addition to this, the connection port 86 may be provided on the lower side of Fig. 17 (on the right side of Fig. 2).

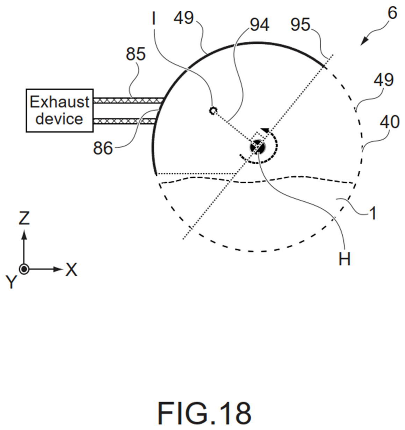

Fig. 18 is a schematic view showing an example of the connection position of the pipe member 85. In the example of Fig. 2, the pipe member 85 is connected to the left side of the side portion 49, but the pipe member 85 may be connected to another position of the side portion 49.

In this example, assuming that the side portion 49 is divided into two by the plane perpendicular to a perpendicular line drawn from the irradiation position I to the rotation axis H and including the rotation axis H, the connection port 86 is provided to a side portion 49, of the divided side portions 49, in which the irradiation position I is present, on the upper side relative to the plasma raw material 1 stored in the raw material container 21.

In other words, Fig. 18 shows the side portions 49 by the broken line and the solid line, and of those, the portion shown by the solid line is provided with the connection port 86. Fig. 18 shows the perpendicular line 94, which is drawn from the irradiation position I to the rotation axis H, by the broken line. The rotation axis H extends along the Y-direction, and thus the perpendicular line 94 is a line segment parallel to the XZ plane (plane of Fig. 18).

In addition, Fig. 18 shows a plane 95 by the broken line. The plane 95 corresponds to the plane perpendicular to the perpendicular line (perpendicular line 94) drawn from the irradiation position I to the rotation axis H and including the rotation axis H. In other words, the plane 95 is a plane perpendicular to the XZ plane and including the rotation axis H.

Assuming that the side portion 49 is divided into two by the plane 95, the side portion 49 having a circumferential shape is divided into the upper left half-arc and the lower right half-arc by the plane 95 as viewed from the Y-direction as shown in Fig. 18. The side portion 49 on the side where the irradiation position I is present is the portion corresponding to the upper left half-arc. An upper portion of the upper left half-arc, which is located above the plasma raw material 1, corresponds to the solid line portion shown in Fig. 18. In other words, the connection port 86 is provided at any position in the solid line portion.

The debris 87 is generated with the irradiation position I as the center, and thus a relatively large amount of debris 87 is distributed at the solid line portion of the side portion 49 due to the centrifugal force or the like. In this example, the connection port 86 is provided at a position of the solid line portion, which makes it possible to more efficiently remove the debris 87.

The cover structure 40 may be provided with a plurality of connection ports 86. In other words, the connection port 86 may be at least one or more of the connection port 86 provided to the side portion 49, the connection port 86 provided to the front-side disk portion 47, or the connection port 86 provided to the back-side disk portion 48.

For example, the disk portion 47, the disk portion 48, and the side portion 49 are respectively provided with the connection ports 86 one by one, which makes it possible to efficiently remove the debris 87 located at various positions. Alternatively, the connection ports 86 may be provided only at the minimum number of necessary locations, such as two locations of the disk portions 47 and 48. In addition, for example, if the debris 87 on the back side is to be removed intensively, a plurality of connection ports 86 may be provided to the back-side disk portion 48.

The pipe member 85 may be branched in the middle and connected to different portions of the cover structure 40. In this case, for example, only one exhaust device 84 is disposed, and the pipe member 85 connected to the one exhaust device 84 is branched into three parts and connected one by one to the disk portion 47, the disk portion 48, and the side portion 49. This eliminates the need for arranging a plurality of exhaust devices 84 and makes it possible to achieve the plasma generation mechanism 6 with a simple configuration.

### <Seventh Embodiment>

### [Configuration of Cover Structure]

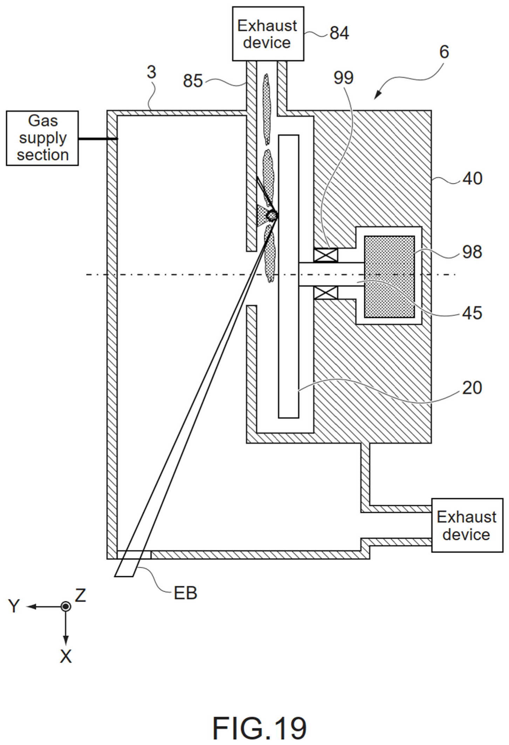

Fig. 19 is a schematic view showing a configuration example of the plasma generation mechanism 6. In this example, the cover structure 40 is configured as a block with thickness in the Y-direction. Similarly to Fig. 3, the rotating body 20 is housed in the left-side portion of the cover structure 40 in Fig. 19, and the pipe member 85 and the exhaust device 84 are connected to the upper portion thereof. On the other hand, a space for housing a motor 98 is provided in the right-side portion of the cover structure 40. In addition, a space through which the shaft portion 45 of the rotating body 20 passes is also provided, and a mechanical seal 99 is provided between the space and the shaft portion 45.

The plasma generation mechanism 6 is configured as described above, so that the motor 98 is stably disposed, and the rotation of the rotating body 20 is prevented from wobbling. Other mechanisms other than the motor 98 may be disposed inside the cover structure 40. Alternatively, the cover structure 40 and the vacuum chamber 3 may be integrally formed.

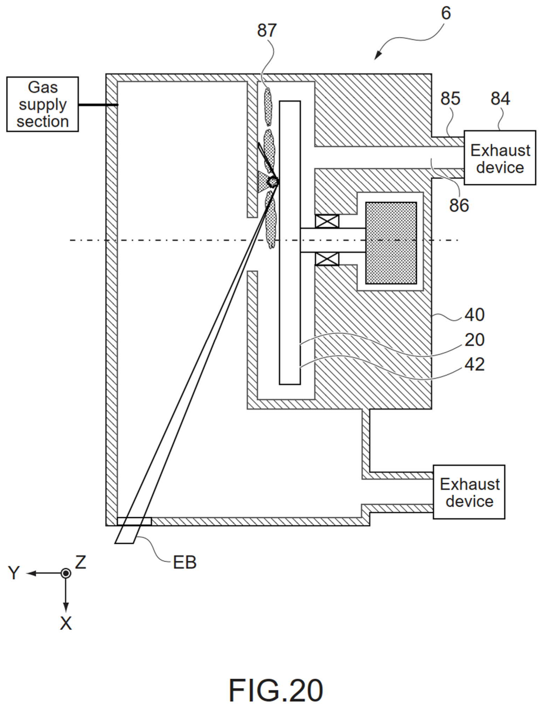

Fig. 20 is a schematic view showing a configuration example of the plasma generation mechanism 6. In this example as well, the cover structure 40 is configured as a block, but the exhaust device 84 is connected to the right side of the cover structure 40 in Fig. 20. Specifically, a flow passage for the debris 87 is provided inside the cover structure 40 so as to extend in the Y-direction from a position opposed to the back surface 42 of the rotating body 20. In addition, the right end of the flow passage serves as the connection port 86, to which the pipe member 85 and the exhaust device 84 are connected.

Even if the cover structure 40 has a block shape in such a manner, it is possible to adopt a configuration in which the pipe member 85 is connected to the back side, so that the debris 87 can be efficiently removed. In addition to the above, the pipe member 85 may be appropriately connected to any position in accordance with a configuration of another mechanism.

### <Other Embodiments>

The present technology is not limited to the embodiments described above, and can achieve other various embodiments.

### [Gas Supply Section]

The light source apparatus 100 may include the gas supply section 82 that generates a gas flow toward the space S from the outside of the cover structure 40. Fig. 3 schematically shows a state in which the gas supply section 82 is connected to the vacuum chamber 3 via the gas nozzle 18.

The gas supply section 82 introduces a gas, such as argon, into the gas nozzle 18. The introduced gas passes through the inside of the gas nozzle 18 and moves to a space that is the inside of the vacuum chamber 3 and the outside of the cover structure 40 (hereinafter, referred to as an external space T of the cover structure 40). The pressure in the external space T is then made higher than the pressure in the space S, and a gas flow from the external space T toward the space S is generated.

This makes it possible to prevent the debris 87 existing in the space S from leaking out of the opening 50 to the external space T. In other words, it possible to retain the debris 87 in the space S and more efficiently remove the debris 87.

In addition, the gas supply section 82 may include a gas supply port located in the vicinity of at least one of the incident region 52 of the energy beam EB or the passage region 53 of the radiation R. For example, the tip of the gas nozzle 18 corresponds to the gas supply port, and the gas nozzle 18 is disposed such that the tip portion extends to the vicinity of the opening 50. This makes it possible to generate a strong gas flow around the opening 50 and to reliably prevent the debris 87 from leaking. In addition, the adhesion of the debris 87 to the opening 50 is further prevented.

Fig. 3 shows the gas supply section 82 and the gas nozzle 18 just schematically, and the specific configurations of their connection positions and the like are not limited. For example, a plurality of gas supply sections 82 and gas nozzles 18 may be connected, or the gas nozzle 18 may be a circular shower or the like. In addition, any other type of gas other than argon gas may be used to the extent that the present technology is feasible.

In addition, in this example, the light source apparatus 100 includes the exhaust device 83 that is connected to communicate with the external space T of the cover structure 40 and can exhaust the external space T. For example, the exhaust pump 17 shown in Fig. 1 may be the exhaust device 83, but its specific configuration is not limited.

The drive ratio of the exhaust device 83 on the vacuum chamber 3 side is lowered with respect to the exhaust device 84 on the cover structure 40 side, and thus the space S is strongly exhausted and the external space T is weakly exhausted. This generates a gas flow from the external space T to the space S. Such a configuration can also prevent the leakage of debris 87 in a similar manner.

The exhaust device 83 corresponds to an embodiment of a second exhaust section according to the present technology.

The external space T of the cover structure 40 corresponds to an inner space of a chamber according to the present technology.

### [Configuration of Disk Portion]

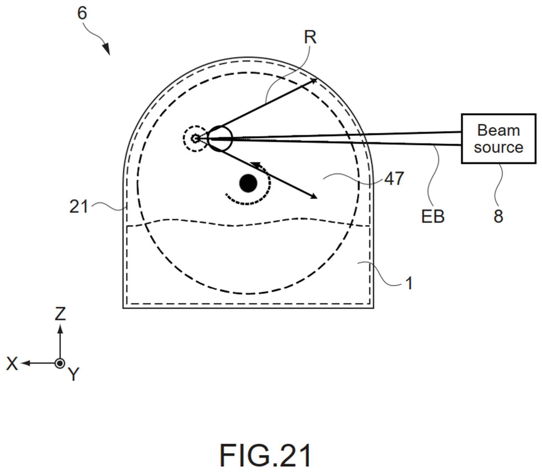

Fig. 21 is a schematic view showing a configuration example of the plasma generation mechanism 6. In this example, the disk portions 47 and 48 are flat plates each having a shape including a circular portion and a flat bottom portion. Specifically, the shape of the disk portion 47 includes a semicircular shape in the upper half and a rectangular shape (square) in the lower half. In other words, the semicircle corresponds to the shape of the circular portion, and the rectangular shape corresponds to the flat bottom portion. In addition, the back-side disk portion 48 also has the shape similar to the disk portion 47.

This makes it possible to increase the volume of the raw material container 21 and to store a large amount of plasma raw material 1, for example, as shown in Fig. 21. Note that, for example, any other configuration including a flat bottom portion, such as a trapezoidal shape in the lower half or a rectangular shape with rounded corners, may be adopted as the shape of the disk portions 47 and 48.

### [Position of Opening]

The specific position of the opening is not limited, and the opening may be provided at any position to the extent that the present technology is feasible. For example, as viewed from the direction of the rotation axis H, the opening is provided inwardly relative to the irradiation position I with the rotation axis H as a reference.

In other words, the opening is provided such that the distance between the rotation axis H and the opening is shorter than the distance between the rotation axis H and the irradiation position I. For example, such openings are the opening 50 of Fig. 2, the opening 61 of Fig. 5, and the openings 71 and 72 of Fig. 10. A large amount of debris generated at the irradiation position I is scattered in the outward direction by the centrifugal force due to the rotation of the rotating body 20. Arranging the openings inwardly relative to the irradiation position I makes it possible to reduce the amount of debris that passes through the openings and to prevent the scattering of debris to the outside of the cover structure 40.

Alternatively, conversely, the opening may be provided outwardly relative to the irradiation position I with the rotation axis H as a reference. Depending on the arrangement of other mechanisms, it may be effective to provide the opening outwardly relative to the irradiation position, and such arrangement of the opening can also be adopted as appropriate.

### [Number of Openings]

Four or more openings may be provided in the disk portion 47. In this case, the energy beam EB may enter or exit two or more openings or the radiation R may be extracted from two or more openings. In addition, monitor light of the energy beam EB or the radiation R may be extracted from the openings, and the state of the light may be monitored. Any other configurations such as a configuration in which any opening has an arc shape, a configuration in which the opening is closed by the damper 68, and a configuration in which each opening has a different shape can be adopted to the extent that the present technology is feasible.

### [Skimmer]

The plasma generation mechanism 6 may include a skimmer that adjusts the thickness of the plasma raw material 1 adhering to the adhesion region 46. The skimmer is, for example, a structure having a channel structure and is disposed at a position just before the irradiation position I of the rotating body 20 (e.g., just on the upper right of the irradiation position I) with a predetermined gap to sandwich the rotating body 20 therein. Of course, the specific configuration of the skimmer is not limited. The skimmer functions as a scraper to scrape off part of the plasma raw material 1 adhering to the adhesion region 46 of the rotating body 20.

This makes it possible to supply the plasma raw material 1 almost uniformly to the irradiation position I and to stabilize the intensity of the radiation R. Note that a mechanism capable of adjusting the thickness of the plasma raw material 1 other than the skimmer may be disposed.

### [Type of Plasma Raw Material]

As the plasma raw material 1, tin, lithium, gadolinium, terbium, gallium, bismuth, indium, or an alloy containing at least one of those materials can be used. For example, if EUV light is extracted as the radiation R and the EUV light is used for a microscope, bismuth is used as a material. In addition, if X-rays are generated as the radiation R, indium is used as a material. Use of those materials makes it possible to generate high-quality radiation R. Other specific types of plasma raw material 1 are not limited.

### [Types of Energy Beam and Radiation]

The specific types of energy beams EB and radiation R are not limited. For example, laser light can be used as the energy beam EB. This makes it possible to generate high-quality radiation R. In addition, for example, extreme ultraviolet (EUV) light or X-rays are generated as the radiation R. This makes it possible to efficiently utilize the radiation R.

### [Application to DPP and LDP]

The present technology is also applicable to a DPP light source apparatus or an LPP light source apparatus. In this case, for example, two rotating bodies are housed in a common cover structure 40 and one or more exhaust devices 84 are connected to the cover structure 40. The debris 87 may be removed in any other form.

The light source apparatus, the plasma generation mechanism, the cover structure, the disk portion, the shielding portion, the opening, the exhaust device, the pipe member, the debris trap, the gas supply section, the gas nozzle, the damper, and the like described with reference to the drawings are mere embodiments and can be modified discretionally without departing from the gist of the present technology. In other words, any other configurations to implement the present technology may be adopted.

In the present disclosure, words such as "substantially" are used to readily understand the explanation, but there is no clear meaning if these words are used or not. In other words, in the present disclosure, concepts that define shape, size, position relationship, state, and the like, such as "center", "middle", "uniform", "equal", "same", "orthogonal", "parallel", "symmetrical", "extending", "axial", "circular", "cylindrical", "arc-shaped", "rectangular", "square", "polygonal", "ring-shaped", "cubic", "rectangular parallelepiped-shaped", "columnar", "disk-shaped", and "cone-shaped", are concepts including "substantially center", "substantially middle", "substantially uniform", "substantially equal", "substantially same", "substantially orthogonal", "substantially parallel", "substantially symmetrical", "substantially extending", "substantially axial", "substantially circular", "substantially cylindrical", "substantially arc-shaped", "substantially rectangular", "substantially square", "substantially polygonal", "substantially ring-shaped", "substantially cubic", "substantially rectangular parallelepiped-shaped", "substantially columnar", "substantially disk-shaped", and "substantially cone-shaped", and the like. The concepts also include concepts having states in a predetermined range (e.g., ±10% range) with reference to, for example, "exactly center", "exactly middle", "exactly uniform", "exactly equal", "exactly same", "exactly orthogonal", "exactly parallel", "exactly symmetrical", "exactly extending", "exactly axial", "exactly circular", "exactly cylindrical", "exactly arc-shaped", "exactly rectangular", "exactly square", "exactly polygonal", "exactly ring-shaped", "exactly cubic", "exactly rectangular parallelepiped-shaped", "exactly columnar", "exactly disk-shaped", and "exactly cone-shaped", and the like. Therefore, even when the words such as "substantially" are not added, the concepts may include those that are expressed by adding so-called "substantially". Conversely, states expressed by adding "substantially" do not necessarily exclude their exact states.

In the present disclosure, expressions using the term "than" such as "greater than A" and "less than A" are expressions that comprehensively include concepts that include the case of being equal to A and concepts that do not include the case of being equal to A. For example, "greater than A" is not limited to the case where it does not include "equal to A"; however, it also includes "equal to or greater than A". Further, "less than A" is not limited to "less than A"; it also includes "equal to or less than A". Upon the implementation of the present technology, specific settings and other settings may be suitably adopted from the concepts that are included in "greater than A" and "less than A" to achieve the effects described above.

Among the characteristic portions according to the present technology described above, at least two of the characteristic portions can also be combined. In other words, the various characteristic portions described in each embodiment may be optionally combined regardless of the embodiments. Further, the various effects described above are merely illustrative and not restrictive, and other effects may be exerted.

### Reference Signs List

- 1: plasma raw material
- 3: vacuum chamber
- 6: plasma generation mechanism
- 8: beam source
- 18: gas nozzle
- 20: rotating body
- 21: raw material container
- 40: cover structure
- 43: immersed region
- 46: adhesion region
- 50, 61, 62, 65, 71 to 73, 76 to 78: opening
- 52: incident region
- 53: passage region
- 60: emission region
- 82: gas supply section
- 83,84: exhaust device
- 85: pipe member
- 86: connection port
- 87: debris
- 90: debris trap
- 100: light source apparatus
- 102: shielding portion

## Claims

1. A light source apparatus that converts a liquid raw material into plasma and extracts radiation by using irradiation with an energy beam, the light source apparatus comprising
a light-emitting unit including
a rotating body that is rotatable about a rotation axis in a direction intersecting with a direction of gravity and includes an adhesion region to which the liquid raw material adheres, and
a shielding body that includes
a space portion to rotatably house the rotating body,
a first energy beam passage portion through which the energy beam to be applied to the adhesion region passes,
a radiation passage portion through which the radiation passes, the radiation being generated by applying the energy beam that has passed through the first energy beam passage portion to the liquid raw material that has adhered to the adhesion region, and
a shielding portion that shields an irradiation position of the energy beam with respect to the adhesion region when viewed from a direction of the rotation axis.

2. The light source apparatus according to claim 1, wherein
the shielding body includes
a front surface portion to which the first energy beam passage portion, the radiation passage portion, and the shielding portion are provided,
a back surface portion opposed to the front surface portion, and
a side portion, and
the space portion is a space surrounded by the front surface portion, the back surface portion, and the side portion.

3. The light source apparatus according to claim 2, wherein
the shielding body includes a second energy beam passage portion provided to the front surface portion, through which the energy beam reflected by the adhesion region passes.

4. The light source apparatus according to claim 3, wherein
the first energy beam passage portion, the radiation passage portion, and the second energy beam passage portion are respectively located in different openings provided to the front surface portion.

5. The light source apparatus according to claim 4, wherein
the front surface portion includes three openings of a first opening, a second opening, and a third opening,
the first energy beam passage portion is located in the first opening,
the radiation passage portion is located in the second opening, and
the second energy beam passage portion is located in the third opening.

6. The light source apparatus according to claim 1 or 2, further comprising
a beam source that applies the energy beam, wherein
the beam source causes the energy beam to be incident on each of the first energy beam passage portion and the adhesion region diagonally with respect to the rotation axis.

7. The light source apparatus according to claim 1 or 2, wherein
the liquid raw material is tin, lithium, gadolinium, terbium, gallium, bismuth, indium, or an alloy containing at least one of those materials.

8. The light source apparatus according to claim 2, further comprising:
a chamber that is capable of maintaining a vacuum atmosphere, the shielding body being disposed inside the chamber; and
a first exhaust section that is connected to communicate with the space portion of the shielding body and is capable of exhausting the space portion.

9. The light source apparatus according to claim 8, wherein
the shielding body includes a connection section to which the first exhaust section is connected,
the connection section includes at least one of a connection port provided to the side portion, a connection port provided to the front surface portion, or a connection port provided to the back surface portion.

10. The light source apparatus according to claim 8 or 9, further comprising
a gas supply section that generates a gas flow toward the space portion from an outside of the shielding body.

11. The light source apparatus according to claim 10, wherein
the gas supply section includes a gas supply port located near at least one of the first energy beam passage portion or the radiation passage portion.

12. The light source apparatus according to claim 8 or 9, wherein
the first exhaust section includes
an exhaust device disposed outside the chamber, and
a debris trap that is disposed between the chamber and the exhaust device and captures debris generated by applying the energy beam to the adhesion region.

13. The light source apparatus according to claim 8 or 9, further comprising
a second exhaust section that is connected to communicate with an inner space of the chamber and is capable of exhausting the inner space such that a pressure of the space portion of the shielding body is lower than a pressure of an outside of the shielding body.

14. A light-emitting unit that converts a liquid raw material into plasma and extracts radiation by using irradiation with an energy beam, the light-emitting unit comprising:
a rotating body that is rotatable about a rotation axis in a direction intersecting with a direction of gravity and includes an adhesion region to which the liquid raw material adheres; and
a shielding body that includes
a space portion to rotatably house the rotating body,
a first energy beam passage portion through which the energy beam to be applied to the adhesion region passes,
a radiation passage portion through which the radiation passes, the radiation being generated by applying the energy beam that has passed through the first energy beam passage portion to the liquid raw material that has adhered to the adhesion region, and
a shielding portion that shields an irradiation position of the energy beam with respect to the adhesion region when viewed from a direction of the rotation axis.
